# EUROPEAN PATENT APPLICATION

(11) **EP 1 643 002 A1**
(43) Date of publication of application: **05.04.2006**
(21) Application number: 04735520.1
(22) Date of filing: 31.05.2004
(51) Int. Cl.: C23C 16/30, C23C 16/505, G02B 1/10

(54) **METHOD FOR FORMING THIN FILM AND ARTICLE WITH THIN FILM**

(30) Priority: 06.06.2003 JP 2003162032; 03.07.2003 JP 2003191025
(71) Applicant: KONICA MINOLTA HOLDINGS, INC., Tokyo 100-0005 (JP)
(72) Inventor: KUDO, Ichiro, Konica Minolta Technology Ctr., Inc, Hino-shi, Tokyo 191-8511 (JP); SAITO, Atsushi, Konica Minolta Techn. Ctr., Inc., Hino-shi, Tokyo 191-8511 (JP); ARITA, Hiroaki, Konica Minolta Techn. Ctr, Inc., Hino-shi, Tokyo 191-8511 (JP)
(74) Representative: McCluskie, Gail Wilson
(86) International application number: PCT/JP2004/007860
(87) International publication number: WO 2004/108984

(57) **Abstract**

A thin film forming method, wherein a discharge gas is introduced into a discharge space to be excited under an atmospheric or approximately atmospheric pressure, a thin film forming gas containing an orgenometallic compound with an organic group containing a fluorine atom being brought into contact with said excited discharge gas outside the discharge space to be converted into an indirectly excited gas, and a substrate is exposed to said indirectly excited gas to form a thin film on said substrate, and a thin film formed substance formed by the same.

## Description

### FIELD OF THE INVENTION

The present invention relates to a thin film forming method and a thin film formed substance, of a new anti-stain film, and particularly to a thin film forming method to form a highly functional anti-stain film, by exposing a substrate to a thin film forming gas containing an organometallic compound with an organic group containing a fluorine atom, and a thin film formed substance prepared thereby.

### TECHNICAL BACKGROUND

At present, it is known that an anti-stain film, which is capable of protecting the surface, preventing adhesion of dirt and dust which may disturb the visibility or easy removing dirt and dust adhered thereon, is provided on such as a touch panel on which human fingers directly touch, the surface of image display devices such as a CRT and a liquid crystal display, the surface of glasses, the surface of a lens, or the surface of transparent materials such as a solar battery and a window pane which are liable to accept dust by being exposed to the open air.

In JP-A No. 2000-144097 (Hereinafter, JP-A refers to Japanese Patent Publication Open to Public Inspection), disclosed is a method to coat a liquid material for anti-stain film formation on the surface of an article as an anti-stain film forming method. Further, in JP-A No. 2-36921, disclosed is a method in which an anti-stain property of the surface is improved by covering an anti-reflection film utilized in such as a liquid crystal display with an organic polysiloxane having a silanol group by means of a coating method.

However, an anti-stain film forming method by means of a coating method has problems in that a substrate material utilized is limited because it requires chemical resistance against a solvent constituting the coating solution, a load on a manufacturing process with respect to a cost because of drying process being required after coating, and when the surface of the substrate has a roughness, a leveling may be caused during a drying process after coating or wetability of a coating solution becomes inappropriate depending on a material to cause coating unevenness or repellency defects resulting in difficulty of forming a uniform anti-stain film having a uniform layer thickness.

In view of the problems described above, in JP-A No. 2003-98303, proposed has been a method in which an anti-stain film is easily formed by use of an atmospheric pressure plasma CVD. According to this method, it requires no drying process, and an anti-stain film having a uniform layer thickness can be stably prepared even with a substrate having a rough surface shape.

However, the above method is an atmospheric pressure plasma method in which an objective substrate is mounted between electrodes and a gas for anti-stain film formation is directly introduced into a discharge space, and has been proved that a satisfactory level is not necessarily achieved with respect to an anti-stain property (for example, such as water-repellency, oil-repellency, and a wiping-off property of sebum or ink).

Further, a method described in JP-A No. 9-59777 is a discharge plasma processing method in which, while a processing gas is supplied into a process section, a discharge plasma generated in an inert gas is ejected towards said process section, however, it has been proved to be difficult to stably provide desired capabilities (such as hydrophilicity and water-repellency) because of utilizing propylene fluoride as a thin film forming gas.

Therefore, an objective of this invention is to provide a thin film forming method, provided with no effects to the substrate, excellent water-repellency, oil-repellency, a wiping-off property of sebum and ink, and repeating durability thereof, as well as an excellent anti-abrasion property, and a thin film formed substance prepared thereby.

### DISCLOSURE OF THE INVENTION

These objectives of this invention can be achieved by a thin film forming method wherein a discharge gas is introduced into a discharge space to be excited under an atmospheric or an approximately atmospheric pressure, said excited gas and a thin film forming gas containing an organometallic compound with an organic group containing a fluorine atom are made into contact outside the discharge space to generate an indirectly excited gas, and a substrate is exposed to said indirectly excited gas to form a thin film on said substrate.

Further, these objectives of this invention also can be achieved by a film layer forming method wherein, while a thin film forming gas containing an organometallic compound with an organic group containing a fluorine atom is supplied on an object to be processed, an excited discharge gas, which has been excited by introducing a discharge gas into a discharge space under atmospheric or approximately atmospheric pressure, is supplied on said object to be processed.

The invention itself, together with further objects and attendant advantages, will best be understood by reference to the following detailed description taken in conjunction with the accompanying drawings.

### BRIEF DESCRIPTION OF THE DRAWINGS

Fig. 1 is a cross-sectional drawing to show an example of an atmospheric pressure plasma discharge processing apparatus which can be utilized in the invention.
Fig. 2 is an oblique view drawing to show the atmospheric pressure plasma discharge processing apparatus of Fig. 1.
Fig. 3 is an oblique view drawing to show another example of an atmospheric pressure plasma discharge processing apparatus which can be utilized in the invention.
Fig. 4 is a cross-sectional drawing to show another example of an atmospheric pressure plasma discharge processing apparatus which can be utilized in the invention.
Fig. 5 is an oblique view drawing of the atmospheric pressure plasma discharge processing apparatus of Fig. 4.
Fig. 6 is an oblique view drawing to show another example of an atmospheric pressure plasma discharge processing apparatus which can be utilized in the invention.
Fig. 7 is an outline drawing to show an example of an atmospheric pressure plasma discharge processing apparatus which is utilized in a pre-treatment according to the invention.
Fig. 8 is an outline drawing to show another example of an atmospheric pressure plasma discharge processing apparatus which is utilized in a surface treatment of a substrate according to the invention.

### BEST MODE FOR CARRYING OUT THE INVENTION

In the following, the invention will be detailed.

A thin film forming method of the invention is characterized by that a discharge gas is introduced into a discharge space to be excited under an atmospheric or approximately atmospheric pressure, said excited gas and a thin film forming gas containing an organometallic compound with an organic group containing a fluorine atom are brought into contact outside the discharge space to be converted into an indirectly excited gas, and a substrate is exposed to said indirectly excited gas to prepare a thin film on said substrate.

First, an organometallic compound provided with an organic group having a fluoride atom which is contained in a thin film forming gas will be detailed.

In an organometallic compound provided with an organic group having a fluoride atom according to the invention, an organic group having a fluorine atom includes such as an alkyl group, an alkenyl group and an aryl group, having a fluorine atom, and organometallic compounds provided with an organic group having a fluoride atom utilized in the invention are those in which these organic groups having a fluorine atom are directly bonded to metals, for example, such as silicon, titanium, germanium, zirconium, tin, aluminum, indium, antimony, yttrium, lanthanum, iron, neodymium, copper, gallium and hafnium. Among these metals, preferable are silicon, titanium, germanium, zirconium and tin and more preferable are silicon and titanium. These organic groups having a fluorine atom may bonds to a metallic compound in any manner; for example, when a compound having a plural number of metallic atoms such as siloxane is provided with these organic groups, it is satisfactory that at least one metallic atom has an organic group having a fluorine atom regardless of the position.

According to a thin film forming method of the invention, it is estimated that excellent effects of the invention are exhibited because an organometallic compound with an organic group containing a fluorine atom easily forms bonds with a substrate comprising such as silica and glass.

Organometallic compounds with an organic group containing a fluorine atom utilized in the invention are preferably compounds represented by aforesaid general formula (1).

In aforesaid general formula (1), M represents Si, Ti, Ge, Zr or Sn. Further, R₁ to R₆ each represent a hydrogen atom or a monovalent group, and at least one of the groups represented by R₁ to R₆ is an organic group having a fluorine atom, for example, preferably an organic group containing an alkyl group, alkenyl group or aryl group having a fluorine atom. An alkyl group having a fluorine atom includes, for example, such as a trifluoromethyl group, a perfluoroethyl group, a perfluoropropyl group, a perfluorobutyl group and a 4,4,3,3,2,2,1,1-octafluorobutyl group, an alkenyl group having a fluorine atom includes, for example, such as a 3,3,3-trifluoro-1-propenyl group, and an aryl group having a fluorine atom includes, for example, such as a pentafluorophenyl group. Further, also utilized can be such as an alkoxy group, an alkenyloxy group and an aryloxy group which are prepared from these alkyl groups, alkenyl groups or aryl groups having a fluorine atom.

Further, in such as the aforesaid alkyl group, alkenyl group and aryl group, any number of fluorine atoms may bond to any positions in their skeletons, however, it is preferable that at least one fluorine atom bonds to the groups. Further, carbon atoms in the skeletons of an alkyl group and an alkenyl group may be substituted, for example, by other atoms such as oxygen, nitrogen and sulfur, or bivalent groups containing such as oxygen, nitrogen and sulfur, for example, groups such as a carbonyl group and a thiocarbonyl group.

Among groups represented by R₁ to R₆ other than the aforesaid organic group having a fluorine atom represent a hydrogen atom or a monovalent group, which, for example, includes groups such as a hydroxyl group, an amino group, an isocyanate group, a halogen atom, an alkyl group, a cycloalkyl group, an alkenyl group, an alkoxy group, an alkenyloxy group and an aryloxy group, however, it is not limited thereto. j represents 0 or an integer of 1 to 150, preferably 0 to 50 and is more-preferably in a range of 0 to 20.

Among aforesaid monovalent groups, a halogen atom is preferably a chlorine atom, a bromine atom or an iodine atom. Further, among an alkyl group, an alkenyl group, an aryl group, an alkoxy group, an alkenyloxy group and an aryloxy group as aforesaid monovalent groups, preferable are an alkoxy group, an alkenyloxy group and an aryloxy group.

Further, among metal atoms represented by M, Si and Ti are preferred.

The aforesaid monovalent groups may be further substituted by other groups, and preferable substituents, although not being specifically limited, include an amino group, a hydroxyl group, an isocyanate group, a halogen atom such as a fluorine atom, a chlorine atom and a bromine atom, an alkyl group, a cycloalkyl group, an alkenyl group, an aryl group such as a phenyl group, alkoxy group, an alkenyloxy group, an aryloxy group, an acyl group, an acyloxy group, an alkoxycarbonyl group, an alkaneamido group, an arylamido group, an alkylcarbamoyl group, an arylcarbamoyl group, a silyl group, an alkylsilyl group and an alkoxysilyl group.

Further, the aforesaid organic groups having a fluorine atom and other groups represented by these R₁ to R₆ may have a structure having a plural number of metal atoms further substituted by a group represented by R¹R²R³M- (M represents the aforesaid metal atom, R¹, R² and R³ each represent a monovalent group, and the monovalent group represents the aforesaid organic group having a fluorine atom or groups other than said organic group having a fluorine atom, which were listed as R₁ to R₆.). These metals include such as Si and Ti, and, for example, listed are such as a silyl group, an alkyl silyl group and an alkoxysilyl group.

An alkyl group and an alkenyl group as groups having a fluorine atom which were listed in aforesaid R₁ to R₆, in an alkyl group, an alkenyl group or an alkoxy group and an alkenyloxy group prepared from them, are preferably groups represented by following general formula (F).

General Formula (F) Rf-X-(CH₂)ₖ-

Herein, Rf represents an alkyl group or an alkenyl group in which at least one of hydrogen is replaced by a fluorine atom, and is preferably, for example, perfluoroalkyl groups such as a trifluoromethyl group, a pentafluoroethyl group, a perfluorooctyl group and a heptafluoropropyl group; such as a 3,3,3-trifluoropropyl group and a 4,4,3,3,2,2,1,1-octafluorobutyl group; or alkenyl groups substituted by a fluorine atom such as 1,1,1-trifluoro-2-chloropropenyl group. Among them, preferable are groups such as a trifluoromethyl group, a pentafluoroethyl group, a perfluorooctyl group and a heptafluoropropyl group, in addition to alkyl groups having two or more fluorine atoms such as a 3,3,3-trifluoropropyl group and a 4,4,3,3,2,2,1,1-octafluorobutyl group.

Further, X is a single bond or a bivalent group, and represents, as a bivalent group, groups such as -O-, -S- and -NR- (R represents a hydrogen atom or an alkyl group) and groups such as -CO-, -CO-O-, -CONH-, -SO₂NH-, -SO₂-O-, - OCONH-, and 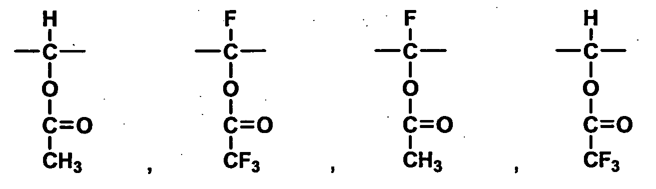 k represents 0 or an integer of 1 to 50 and preferably 0 or an integer of 1 to 30.

Other substituents in addition to a fluorine atom may be substituted in Rf, and substitutable groups include those similar to groups listed as substituents in aforesaid R₁ to R₆. Further, skeleton carbon atoms in Rf may be partly substituted, for example, by groups such as -O-, -S-, -NR₀₋(R₀ represents a hydrogen atom or a substituted or non-substituted alkyl group, and may be groups represented by aforesaid formula (F)), a carbonyl group, -NHCO-, -CO-O- and -SO₂NH-.

Among compounds represented by aforesaid general formula (1), preferable are compounds represented by following general formula (2).

General Formula (2) [Rf-X-(CH₂)ₖ]_{q}-M(R₁₀)ᵣ(OR₁₁)ₜ

In general formula (2), M represents a metal atom similar to that in the aforesaid general formula (1), and k represents also the same integer. R₁₀ represents an alkyl group or an alkenyl group, and R₁₁ represents an alkyl group, an alkenyl group or an aryl group; each may be substituted by similar groups listed as substituents of R₁ to R₆ in general formula (1), however, preferably represents a non-substituted alkyl group or alkenyl group. Further, q + r + t = 4, q ≥ 1 and t ≥ 1. Further, two of R₁₀ may bond to form a ring when r ≥ 2.

In general formula (2), furthermore preferable are compounds represented by following general formula (3).

General Formula (3) Rf -X- (CH₂) ₖ-M (OR₁₂)₃

Herein, Rf, X and k have the same definitions as those in foregoing general formula (2). Further, R₁₂ has the same definition as R₁₂ in foregoing general formula (2). And M also has the same definition as M in foregoing general formula (2), however, specifically preferably is Si or Ti and most preferably Si.

In the invention, other preferable examples of organometallic compounds having a fluorine atom include compounds represented by foregoing general formula (4).

R₁ to R₆ in foregoing general formula (4) have the same definitions as R₁ to R₆ in foregoing general formula (1). Herein, also at least one of R₁ to R₆ is the foregoing organic group having a fluorine atom and preferably groups represented by foregoing general formula (F). R₇ represents a hydrogen atom, or a substituted or non-substituted alkyl group. Further, j represents 0 or an integer of 1 to 100, preferably 0 to 50 and j is most preferably in a range of 0 to 20.

Other preferable compounds having a fluorine atom in the invention include organometallic compounds having a fluorine atom represented by following general formula (5).

General Formula (5) [Rf-X-(CH₂)ₖ-Y]ₘ-M(R₈)ₙ(OR₉)ₚ

In general formula (5), M represents In, Al, Sb, Y or La. Rf and X represent groups similar to Rf and X in foregoing general formula (F). Y represents a single bond or oxygen. k similarly also represents 0 or an integer of 1 to 50 and preferably 0 or an integer of 1 to 30. R₉ represents an alkyl group or an alkenyl group, and R₈ represents an alkyl group, an alkenyl group or an aryl group; each may be substituted by similar groups listed as substituents of R₁ - R₆ in general formula (1). Further, in general formula (5), m + n + p = 3, m being at least 1, and n represents 0 to 2 and p also represents 0 to 2. It is preferable that m + n = 3, that is, n = 0.

Other preferable compounds having a fluorine atom in the invention include organometallic compounds having a fluorine atom represented by following general formula (6).

General Formula (6) R^{f1}(OC₃F₆)ₘ₁-O-(CF₂) ₙ₁- (CH₂)ₚ₁-Z-(CH₂)_{q1}-Si-(R²) ₃

In general formula (6), R^{f1} represents a straight chain or blanched chain perfluoroalkyl group having a carbon number of 1 to 16, R² represents a hydrolysable group and Z represents -OCONH- or -O-; ml represents 0 or an integer of 1 to 50, n1 represents 0 or an integer of 1 to 3, p1 represents 0 or an integer of 1 to 3, q1 represents an integer of 1 to 6, and 6 ≥ n1 + p1 > 0.

The carbon number of a straight chain or branched chain perfluoroalkyl group which can be introduced into R^{f1} is more preferably 1 to 16, and most preferably 1 to 3. Therefore, R^{f1} is preferably such as -CF3, -C₂F₅ and -C₃F₇.

Hydrolysable groups which can be introduced in R² are preferably such as -Cl, -Br, -I, -OR¹¹, -OCOR¹¹, - CO(R¹¹)C=C(R¹²)₂, -ON=C(R¹¹)₂, -ON=CR¹³, -N(R¹²)₂ and -R¹²NOCR¹¹. R¹¹ represents an aliphatic hydrocarbon group having a carbon number of 1 to 10 such as an alkyl group, or an aromatic hydrocarbon group having a carbon number of 6 to 20 such as a phenyl group, R¹² represents a hydrogen atom or an aliphatic hydrocarbon group having a carbon number of 1 to 5 such as an alkyl group, and R¹³ represents a bivalent aliphatic hydrocarbon group having a carbon number of 3 to 6 such as an alkylidene group. Among these hydrolysable groups,
preferable are -OCH₃, -OC₂H₅, -OC₃H₇, -OCOCH₃ and -NH₂.

ml in foregoing general formula (6) is more preferably 1 to 30 and furthermore preferably 5 to 20. n1 is more preferably 1 or 2, and p1 is more preferably 1 or 2.
Further, q1 is more preferably 1 to 3.

Other preferable compounds having a fluorine atom in the invention include organometallic compounds having a fluorine atom represented by foregoing general formula (7).

In foregoing general formula (7), Rf represents a straight chain or branched chain perfluoroalkyl group having a carbon number of 1 to 16, X represents a iodine atom or a hydrogen atom, Y represents a hydrogen atom or a lower alkyl group, Z represents a fluorine atom or a trifluoromethyl group, R²¹ represents a group being hydrolyzable, R²² represents a hydrogen atom or an inert monovalent group, and a, b, c and d each represent 0 or an integer of 1 to 200, e represents 0 or 1, m represents 0 or an integer of 1 to 2 and p represents an integer of 1 to 10.

In foregoing general formula (7), Rf represents a straight chain or branched chain perfluoroalkyl group having a carbon number of 1 to 16, and preferably is a CF₃, C₂F₅ or C₂F₅ group. Lower alkyl groups of Y generally include those having a carbon number of 1 to 5.

A hydrolysable group of R²¹ is preferably a halogen atom such as a chlorine atom, a bromine atom and an iodine atom, R²³O group, R²³COO group, (R²⁴)₂C=C(R²³)CO group,
(R²³) ₂C=NO group, (R²⁴) ₂N group or R²³CONR²⁴ group. Herein, R²³ is an aliphatic hydrocarbon group having generally a carbon number of 1 to 10 such as an alkyl group or an aromatic hydrocarbon having generally a carbon number of 6 to 20, R²⁴ is a hydrogen atom or a lower aliphatic hydrocarbon group having generally a carbon number of 1 to 5 such as an alkyl group, and R²⁵ is a bivalent aliphatic hydrocarbon group having generally a carbon number of 3 to 6 such as an alkylidene group, and furthermore preferably a chlorine atom, CH₃O group, C₂H₅O group or C₃H₇O group.

R²² is a hydrogen atom or an inert monovalent organic group and preferably a hydrocarbon group having generally a carbon number of 1 to 4 such as an alkyl group. a, b, c and d are 0 or an integer of 1 to 200 and preferably 1 to 50. m and n are 0 or an integer of 1 to 2 and preferably 0. p is an integer of not less than 1, preferably 1 to 10 and more preferably an integer of 1 to 5. Further, an average molecular weight is 5 x 10² to 1 x 10⁵ and preferably 1 x 10³ to 1 x 10⁴.

Further, a preferable structure of silane compounds represented by aforesaid general formula (7) are those in which Rf is C₃F₇ group, a is integers of 1 to 50, b, c and d are 0, e is 1, Z is a fluorine atom and n is 0.

In the invention, listed below are organometallic compounds with an organic group containing a fluorine atom which are preferably utilized as a silane compound having a fluorine atom and typical examples of compounds represented by aforesaid general formula (1) to (7), however, the invention is not limited to these compounds.
1: (CF₃CH₂CH₂)₄Si
2: (CF₃CH₂CH₂)₂(CH₃)₂Si
3 : (C₈F₁₇CH₂CH₂)Si (OC₂H₅)₃
4:CH₂=CH₂Si(CF₃)₃
5:(CH₂=CH₂COO)Si(CF₃)₃
6:(CF₃CH₂CH₂)₂SiCl(CH₃)
7:C₈F₁₇CH₂CH₂Si(Cl)₃
8:(C₈F₁₇CH₂CH₂)₂Si(OC₂H₅)₂
9:CF₃CH₂CH₂Si(OCH₃)₃
10:CF₃CH₂CH₂SiCl₃
11:CF₃(CF₂)₃CH₂CH₂SiCl₃
12:CF₃(CF₂)₅CH₂CH₂SiCl₃
13:CF₃(CF₂)₅CH₂CH₂Si(OCH₃)₃
14:CF₃(CF₂)₇CH₂CH₂SiCl₃
15:CF₃(CF₂)₇CH₂CH₂Si(OCH₃)₃
16:CF₃(CF₂)₈CH₂Si(OC₂H₅)₃
17:CF₃(CH₂)₂Si(OC₂H₅)₃
18:CF₃(CH₂)₂Si(OC₃H₇)₃
19:CF₃(CH₂)₂Si(OC₄H₉)₃
20:CF₃(CF₂)₅(CH₂)₂Si(OC₂H₅)₃
21: CF₃(CF₂)₅(CH₂)₂Si(OC₃H₇)₃
22:CF₃(CF₂)₇(CH₂)₂Si(OC₂H₅)₃
23:CF₃(CF₂)₇(CH₂)₂Si(OC₃H₇)₃
24:CF₃(CF₂)₇(CH₂)₂Si(OCH₃)(OC₃H₇)₂
25:CF₃(CF₂)₇(CH₂)₂Si(OCH₃)₂OC₃H₇
26: CF₃(CF₂)₇(CH₂)₂SiCH₃(OCH₃)₂
27: CF₃(CF₂)₇(CH₂)₂SiCH₃(OC₂H₅)₂
28:CF₃(CF₂)₇(CH₂)₂SiCH₃(OC₃H₇)₂
29:(CF₃)₂CF(CF₂)₈(CH₂)₂Si(OCH₃)₃
30: C₇F₁₅CONH(CH₂)₃Si(OC₂H₅)₃
31:C₈F₁₇SO₂NH(CH₂)₃Si(OC₂H₅)₃
32 : C₈F₁₇(CH₂)₂OCONH(CH₂)₃Si(OCH₃)₃
33 : CF₃(CF₂)₇(CH₂)₂Si(CH₃)(OCH₃)₂
34:CF₃(CF₂)₇(CH₂)₂Si(CH₃)(OC₂H₅)₂
35:CF₃(CF₂)₇(CH₂)₂Si(CH₃)(OC₃H₇)₂
36:CF₃(CF₂)₇(CH₂)₂Si(C₂H₅)(OCH₃)₂
37:CF₃(CF₂)₇(CH₂)₂Si(C₂H₅)(OC₃H₇)₂
38 :CF₃(CH₂)₂Si(CH₃)(OCH₃)₂
39:CF₃(CH₂)₂Si(CH₃)(OC₂H₅)₂
40:CF₃(CH₂)₂Si(CH₃)(OC₃H₇)₂
41:CF₃(CF₂)₅(CH₂)₂Si(CH₃)(OCH₃)₂
42 : CF₃(CF₂)₅(CH₂)₂Si(CH₃)(OC₃H₇)₂
43:CF₃(CF₂)₂O(CF₂)₃(CH₂)₂Si(OC₃H₇)₃
44:C₇F₁₅CH₂O(CH₂)₃Si (OC₂H₅)₃
45:C₈F₁₇SO₂O(CH₂)₃Si(OC₂H₅)₃
46:C₈F₁₇(CH₂)₂OCHO(CH₂)₃Si(OCH₃)₃
47:CF₃(CF₂)₅CH(C₄H₉)CH₂Si(OCH₃)₃
48:CF₃(CF₂)₃CH(C₄H₉)CH₂Si(OCH₃)₃
49:(CF₃)₂(p-CH₃-C₆H₅)COCH₂CH₂CH₂Si(OCH₃)₃
50:CF₃CO-O-CH₂CH₂CH₂Si(OCH₃)₃
51:CF₃ (CF₂)₃CH₂CH₂Si(CH₃)Cl
52: CF₃CH₂CH₂(CH₃)Si (OCH₃)₂
53:CF₃CO-O-Si(CH₃)₃
54:CF₃CH₂CH₂Si(CH₃)Cl₂
55:(CF₃)₂(p-CH₃-C₆H₅)COCH₂CH₂Si(OCH₃)₃
56: (CF₃)₂(p-CH₃-C₆H₅)COCH₂CH₂Si(OC₆H₅)₃
57:(CF₃C₂H₄)(CH₃)₂Si-O-Si(CH₃)₃
58:(CF₃C₂H₄)(CH₃)₂Si-O-Si(CF₃C₂H₄)(CH₃)₂
59:CF₃(OC₃F₆)₂₄-O-(CF₂)₂-CH₂-O-CH₂Si(OCH₃)₃
60:CF₃O(CF(CF₃)CF₂O)ₘCF₂CONHC₃H₆Si(OC₂H₅)₃ (m=11 - 30),
61:(C₂H₅O)₃SiC₃H₆NHCOCF₂O(CF₂O)ₙ(CF₂CF₂O)ₚCF₂CONHC₃H₆Si(OC₂H₅)₃ (n/p is approximately 0.5, number average molecular weight is approximately 3000)
62:C₃F₇-(OCF₂CF₂CF₂)q-O-(CF₂)₂-[CH₂CH{Si-(OCH₃)₃}]₉-H (q is approximately 10)
63:F(CF(CF₃)CF₂O)₁₅CF(CF₃)CONHCH₂CH₂CH₂Si(OC₂H₅)₃
64:F(CF₂)₄[CH₂CH(Si(OCH₃)₃)]_{2.02}OCH₃
65 : (C₂H₅O)₃SiC₃H₆NHCO-[CF₂(OC₂F₄)₁₀(OCF₂)₆OCF₂]-CONHC₃H₆Si(OC₂H₅)₃
66: C₃F₇(OC₃F₆)₂₄O(CF₂)₂CH₂OCH₂Si(OCH₃)₃
67: CF₃(CF₂)₃(C₆H₄)C₂H₄Si(OCH₃)₃
68: (CF₃)₂CF(CF₂)₆CH₂CH₂SiCH₃(OCH₃)₂
69:CF₃(CF₂)₃(C₆H₄)C₂H₄SiCH₃(OCH₃)₂
7 0 : CF₃(CF₂)₅(C₆H₄)C₂H₄Si(OC₂H₅)₃
71:CF₃(CF₂)₃C₂H₄Si(NCO)₃
72: CF₃(CF₂)₅C₂H₄Si(NCO) ₃
73:C₉F₁₉CONH(CH₂)₃Si(OC₂H₅)₃
74:C₉F₁₉CONH(CH₂)₃SiCl₃
75:C₉F₁₉CONH(CH₂)₃Si(OC₂H₅)₃
76:C₃F₇O(CF(CF₃)CF₂O)₂-CF(CF₃)-CONH(CH₂)Si(OC₂H₅)₃
77:CF₃O(CF(CF₃)CF₂O)₆CF₂CONH(CH₂)₃SiOSi(OC₂H₅)₂(CH₂)₃NHCOCF₂(OCF₂ CF(CF₃))₆OCF₃
78:C₃F₇COOCH₂Si(CH₃)₂OSi(CH₃)₂CH₂OCOC₃F₇
79:CF₃(CF₂)₇CH₂CH₂O(CH₂)₃Si(CH₃)₂OSi(CH₃)₂(CH₂)₃OCH₂CH₂(CF₂)₇CF₃
8 0 : CF₃ (CF₂) ₅CH₂CH₂O(CH₂)₂Si (CH₃) ₂OSi(CH₃) ₂ (OC₂H₅)
81: CF₃(CF₂)₅CH₂CH₂O(CH₂)₂Si(CH₃)₂OSi(CH₃) (OC₂H₅)₂
82 : CF₃ (CF₂) ₅CH₂CH₂O (CH₂) ₂Si (CH₃) ₂OSi(CH₃) ₂OSi(CH3)₂ (OC₂H₅)
   As other than the compounds exemplified above, listed are fluorine substituted alkoxysilane such as;
83: (perfluoropropyloxy)dimethylsilane
84: tris(perfluoropropyloxy)methylsilane
85: dimethylbis(nonafluorobutoxy)silane
86: methyltris(nonafluorobutoxy)silane
87: bis(perfluoropropyloxy)diphenylsilane
88: bis(perfluoropropyloxy)methylvinylsilane
89: bis(1,1,1,3,3,4,4,4-octafluorobutoxy)dimethysilane
90: bis(1,1,1,3,3,3-hexafluoroisopropoxy)dimethysilane
91: tris(1,1,1,3,3,3-hexafluoroisopropoxy)methysilane
92: tetrakis(1,1,1,3,3,3-hexafluoroisopropoxy)silane
93: dimethylbis(nonafluoro-t-butoxy)silane
94: bis(1,1,1,3,3,3-hexafluoroisopropoxy)diphenlsilane
95: tetrakis(1,1,3,3-tetrafluoroisopropoxy)silane
96: bis[1,1-bis(trifluoromethyl)ethoxy]dimethylsilane
97: bis(1,1,1,3,3,4,4,4-octafluoro-2-butoxy)dimethylsilane
98: methyltris[2,2,3,3,3-pentafluoro-1,1-bis(trifluoromethyl)propoxy]silane
99: diphenylbis[2,2,2-trifluoro-1-(trifluoromethyl) -1-tolylethoxy]silane
   In addition to the following compounds;
100: (CF₃CH₂)₃Si(CH₂-NH₂)
101: (CF₃CH₂)₃Si-N(CH₃)₂
102 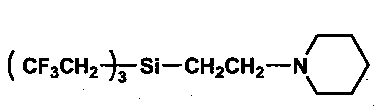
103 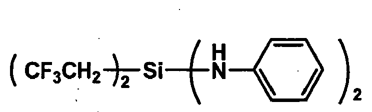
   Further, silazane series such as;
104 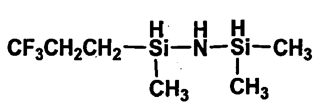
105 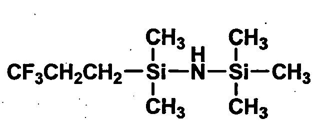
   Organotitanium compound provided with fluorine such as;
106:CF₃CH₂-CH₂TiCl₃
107:CF₃(CF₂)₃CH₂CH₂TiCl₃
108:CF₃(CF₂)₅CH₂CH₂Ti(OCH₃)₃
109:CF₃(CF₂)₇CH₂CH₂TiCl₃
110:Ti(OC₃F₇)₄
111: (CF₃CH₂-CH₂O)₃TiCl₃
112: (CF₃C₂H₄)(CH₃)₂Ti-O-Ti(CH₃)₃
   and can be listed are the following fluorine containing organometallic compounds.
113:CF₃(CF₂)₃CH₂CH₂O(CH₂)₃GeCl
114:CF₃(CF₂)₃CH₂CH₂OCH₂Ge(OCH₃)₃
115: (C₃F₇O)₂Ge(OCH₃)₂
116: [(CF₃)₂CHO]₄Ge
117: [(CF₃)₂CHO]₄Zr
118: (C₃F₇CH₂CH₂)₂Sn(OC₂H₅)₂
119: (C₃F₇CH₂CH₂)Sn (OC₂H₅)₃
120:Sn(OC₃F₇)₄
121: CF₃CH₂CH₂In(OCH₃)₂
122 : In (OCH₂CH₂OC₃F₇)₃
123:Al(OCH₂CH₂OC₃F₇)₃
124:Al(OC₃F₇)₃
125:Sb(OC₃F₇)₃
126 : Fe (OC₃F₇)₃
127 : Cu (OCH₂CH₂OC₃F₇)₂
128: C₃F₇(OC₃F₆)₂₄O(CF₂)₂CH₂OCH₂Si(OCH₃)₃
129

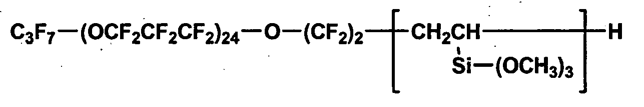

Each compound listed as a specific example is easily available on the market from such as Dow Corning-Toray Silicone Co., Ltd., Shin-Etsu Chemical Co., Ltd., Daikin Chemicals Co., Ltd. (for example Optool DSX) and Gelest Inc.; in addition, it can be prepared according to a synthesizing method or one in accordance therewith, for example, described in such as J. Fluorine Chem., 79(1), 87(1996); Zairyo Gijutsu, 16(5), 209(1998); Collect. Czech. Chem. Commun., Vol. 44, pp. 750 - 755; J. Amer. Chem. Soc. Vol. 112, pp. 2341 - 2348(1990); Inorg. Chem., Vol. 10, pp. 889 - 892(1971); USP No. 3,668,233; or JP-A Nos. 58-122979, 7-242675, 9-61605, 11-29585, 2000-64348 and 2000-144097.

In the thin film forming method of the invention, as described above, a thin film is formed by introducing a discharge gas into a discharge space to be excited under an atmospheric or approximately atmospheric pressure, which is brought in contact with a thin film forming gas containing the aforesaid organometallic compound with an organic group containing a fluorine atom outside the discharge space to be converted into an indirectly excited gas, and exposing a substrate thereto.

When a discharge gas directly exposed in a discharge space and a thin film forming gas are brought into contact outside the discharge space, said thin film forming gas is estimated to be indirectly excited by receiving energy from said discharge gas having been excited in a discharge space. In the invention, a thin film forming gas treated in this manner is called as an indirectly excited gas.

Although the principle is not clear, the inventors have found that the method of the invention can form an anti-stain film having an excellent capability as well as being formed at a high speed, compared to utilizing a thin film forming gas by being directly exposed into a discharge space.

In the invention, a discharge space means the space which is sandwiched by a pair of electrodes arranged opposing to each other at a predetermined distance, and generates discharge by introducing a discharge gas between said electrode pair while being applied with a voltage. Outside of a discharge space refers to a space other than the aforesaid discharge space.

The form of a discharge space is not specifically limited and may be, for example, either a slit form by plate electrode pair opposing to each other or a space of a circumferential form between two cylindrical electrodes.

"Under an atmospheric or approximately atmospheric pressure" means "under a pressure of 20 to 200 kPa". In the invention, a furthermore preferable pressure between the electrodes being applied with a voltage is 70 to 140 kPa.

Next, with respect to an atmospheric pressure plasma discharge processing apparatus, an atmospheric pressure plasma discharge processing method and an electrode system for an atmospheric pressure plasma discharge processing apparatus, which are utilized in the invention, the embodiment will be explained in the following in reference to drawings, however, the invention is not limited thereto. Further, in the following explanation, some technical terms may include decisive expressions, however, they only indicate a preferable example of the invention and do not limit the technological range of terms of the invention.

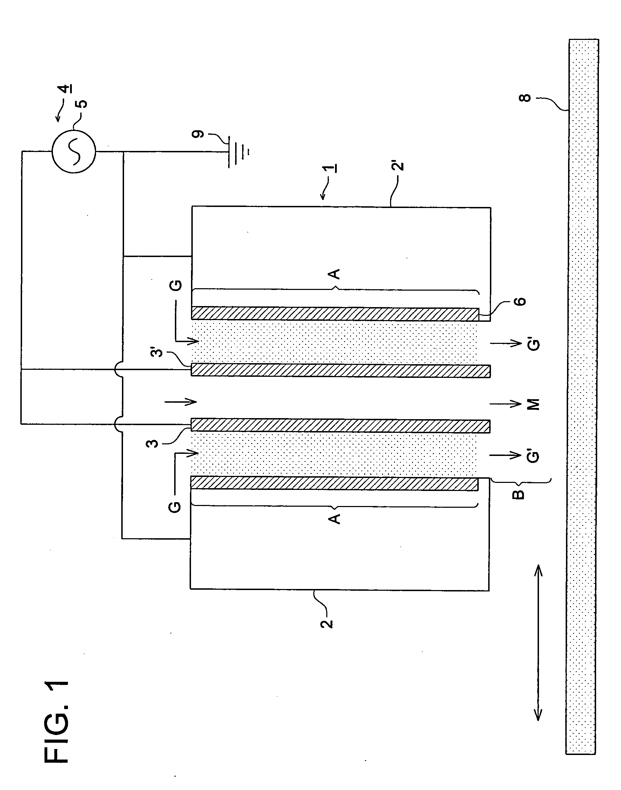

Fig. 1 is a cross-sectional drawing to show an example of an atmospheric pressure plasma discharge apparatus which is useful for the invention.

In the following, an atmospheric pressure plasma discharge processing apparatus means an apparatus in which a discharge gas is introduced into discharge space to be excited under an atmospheric or approximately atmospheric pressure, which are brought into contact with a thin film forming gas outside the discharge space to be converted into an indirectly excited gas, and a substrate is exposed to the indirectly excited gas to form a thin film on said substrate.

In Fig. 1, atmospheric pressure plasma discharge processing apparatus 1 is constituted of primarily such as, opposing electrodes in which first electrode 2 and second electrode 3, and first electrode 2' and second electrode 3', are arranged opposing to each other respectively, voltage applying means 4, high frequency electric power source 5 which applies a high frequency electric field between the opposing electrodes, in addition, a gas supplying means to introduce a discharge gas into a discharge space and to introduce a thin film forming gas outside of the discharge space, and an electrode temperature controlling means to control the temperature of the aforesaid electrodes.

A discharge space is region A which is sandwiched by first electrode 2 and second electrode 3, or by first electrode 2' and second electrode 3', as well as provided with a dielectric element on the first electrodes, indicated as shaded portions in the drawing. A discharge gas is introduced into this discharge space and excited. Discharge is not generated in a space sandwiched by two electrode pairs (a region sandwiched by second electrodes 3 and 3'), and thin film forming gas M containing an organometallic compound with an organic group containing a fluorine atom is introduced therein. Successively, thin film forming gas M is brought into contact with excited gas G' outside the region of discharge space B to be converted into an indirectly excited gas, and the surface of substrate 8 is exposed to this indirectly excited gas to form a thin film. Herein, as substrate 8, processed can be not only a sheet form substrate like a support material but various sizes and forms of substrates. For example, a thin film can be formed on substrates having a thickness such as of a lens form and a spherical form.

In a thin film layer forming method of the invention, a thin film exhibiting an excellent water-repellency, oil-repellency, a wiping-off property of sebum and ink, and repeating durability thereof as well as superior abrasion resistance can be obtained by utilizing an organometallic substance with an organic group containing a fluorine atom, and bringing a thin film forming gas into contact with an excited gas outside the region of a discharge space to be converted into an indirectly excited gas.

A pair of electrodes (first electrode 2 and second electrode 3, or first electrode 2' and second electrode 3') comprising a metallic base material and a dielectric substance, and may be constituted of a combination of a metallic base material and a lining treatment to cover said metallic base material with a dielectric substance having inorganic properties, or may be constituted of a combination of ceramics thermally sprayed on a metallic base material and successive covering with a dielectric substance having been subjected to a sealing treatment by a substance having inorganic properties. As a metallic base material, can be utilized are metals such as silver, platinum, stainless steel, aluminum, iron, titanium, copper and gold. Further, as a dielectric lining material, can be utilized are such as silicate-type glass, borate-type glass, phosphate-type glass, germanate-type glass, tellurite-type glass, aluminate-type glass and vanadate-type glass, and among them preferable is borate-type glass with respect to easy manufacturing. Further, as ceramics utilized for thermally spraying of a dielectric substance, alumina is preferred and is preferably sealed with such as silicon oxide. As a sealing treatment, an alkoxysilane-type sealing material can be made inorganic by a sol-gel reaction.

Further, in Fig. 1, plate electrodes like first electrode 2 and second electrode 3 or first electrode 2' and second electrode 3' are employed as opposing electrodes, however, one or both of the electrodes may be also comprised of a hollow cylindrical or prismatic electrode. High frequency electric power source 5 is connected to one of the opposing electrodes and another electrode is grounded by earth 9, so that a voltage can be applied between the opposing electrodes. Further, on the contrary to the constitution shown in Fig. 1, possible is a constitution in which first electrodes 2 and 2' are applied with a voltage and second electrode 3 and 3' are grounded.

A voltage is applied to each electrode pair from high frequency electric power source 5 as voltage applying means 4. A high frequency electric power source utilized in the invention is not specifically limited. As a high frequency electric power source, utilized can be such as High Frequency Electric power source (3 kHz) produced by Shinko Electric Co., Ltd., High Frequency Electric power Source (5 kHz) produced by Shinko Electric Co., Ltd., High Frequency Electric power source (15 kHz) produced by Shinko Electric Co.; Ltd., High Frequency Electric power source (50 kHz) produced by Shinko Electric Co., Ltd., High Frequency Electric power source (being operated in a continuous mode at 100 kHz) produced by HAIDEN LABOLATORY, High Frequency Electric power source (200 kHz) produced by Pearl Industrial Co., Ltd., High Frequency Electric power source (800 kHz) produced by Pearl Industrial Co., Ltd., High Frequency Electric power source (2 MHz) produced by Pearl Industrial Co., Ltd., High Frequency Electric power source (13.56 MHz) produced by Nippon Denshi Co., Ltd., High Frequency Electric power source (27 MHz) produced by Pearl Industrial Co., Ltd. and High Frequency Electric power source (150 MHz) produced by Pearl Industrial Co., Ltd. Further, also utilized can be an electric power source which oscillates at 433 MHz, 800 MHz, 1.3 GHz, 1.5 GHz, 1.9 GHz, 2.45 GHz, 5.2 GHz or 10 GHz.

A frequency number of high frequency electric field applied between opposing electrodes in the case of forming an anti-stain film according to the invention is not specifically limited, however, it is preferably not lower than 0.5 kHz and not higher than 2.45 GHz, as a high frequency electric power source. Further, an electric power density supplied between the opposing electrodes is preferably not less than 1 W/cm² and not more than 50 W/cm². Herein, a voltage supplying area (cm²) in the opposing electrodes indicates the area of a region where discharge is caused. High frequency voltage applied between the opposing electrodes may be either of an intermittent pulse wave or a continuous sine wave.

In the invention, a distance between opposing electrodes is determined in consideration of such as a thickness of dielectric substance on a metallic base material constituting the electrodes, a voltage applied, and purposes of utilizing plasma. Defining a distance between electrodes to be the minimum distance between a dielectric substance and an electrode in the case of a dielectric substance being arranged on one of the aforesaid electrodes, and to be a distance between both dielectric substances in the case of a dielectric substance being arranged on both of the aforesaid electrodes, it is preferably 0.1 to 20 mm and more preferably 0.2 to 10 mm, with respect to performing a uniform discharge in either case.

In thin film formation according to the invention, a substrate may be exposed to a discharge space separately prepared before being subjected to the thin film formation. Further, prior to thin film formation, the substrate surface may be subjected to a charge neutralizing treatment as well as to dust elimination. As a charge neutralizing means and a dust removing means after neutralization, employed may be a high density charge neutralizing device (JP-A No. 7-263173) in which a neutralizing device comprising a plural number of neutralization electrodes for generation of positive and negative ions, and ion absorbing electrodes being arranged so as to sandwich a substrate, and a positive and negative direct current type neutralization device behind them, in addition to a conventional blower type or contact type. Further, a dust eliminating means after a neutralization treatment can include such as a non-contact and jet air type reduced pressure dust eliminating apparatus (JP-A 7-60211) which may be also preferably utilized, however, it is not limited thereto.

Next, a discharge gas supplied into a discharge space will be explained.

A discharge gas means a gas which can cause discharge. A discharge gas includes such as nitrogen, an inert gas, air, hydrogen and oxygen, and these can be utilized alone or in combination as a discharge gas. The amount of a discharge gas is preferably 70 to 100 volume% based on the total gas amount supplied into a discharge space.

Further, a thin film forming gas according to the invention means a gas containing the aforesaid organometallic compound with an organic group containing a fluorine atom and being chemically deposited on a substrate to form a thin film. The content of the aforesaid organometallic compound with an organic group containing a fluorine atom against a thin film forming gas is preferably in a range of 0.001 to 30.0 volume%.

A thin film forming gas of the invention can contain such as nitrogen and an inert gas which were explained as the aforesaid discharge gas. Herein, a thin film forming gas of the invention may be utilized by being mixed with 0.001 to 30.0 volume% of a subsidiary gas which accelerates the reaction such as a hydrogen gas, an oxygen gas, a nitrogen gas and air.

A material processed by a thin film forming method according to the invention is not specifically limited and includes such as metal oxides, plastics, metals, pottery, paper, wood, non-woven fabric, a glass plate, ceramics and building materials, particularly, it is preferable that the surface of a substrate contains an inorganic compound or an organic compound, with respect to achieving aimed effects of the invention; among them furthermore preferable are substrate having a surface comprising metal oxides such as silica and titania as a primary component. Further, the form of a substrate may be either a sheet-form or a molded-form, and glass includes such as sheet glass and a lens, while plastics includes a plastic lens, plastic film, a plastic sheet and a molded plastic product. When a substrate comprises a plastic resin, it is preferable that a metal oxide film is formed on the surface.

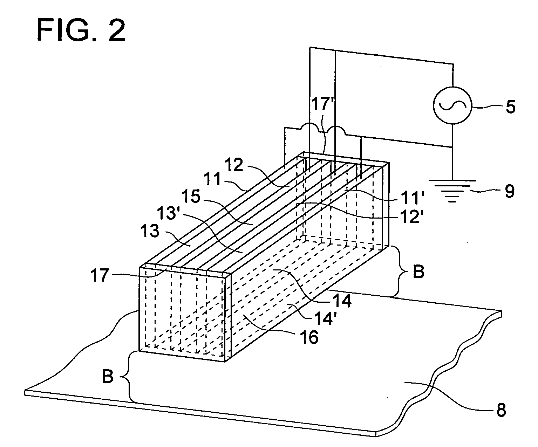

Fig. 2 is an oblique view drawing of the atmospheric pressure discharge apparatus shown in Fig. 1 which is useful in the invention.

11, 12, 11', 12' are plate electrodes of the same size rectangle, plate electrode 11 and plate electrode 12, and plate electrode 11' and plate electrode 12', each pair constitutes an opposing electrodes. The two pairs of electrodes are arranged parallel. Further, each electrode is arranged so as to agree the four corners. A dielectric substance similar to that explained in Fig. 1 covers each of the opposing surfaces of plate electrodes 11 and 12, and plate electrodes 11' and 12'. Herein, in the invention, it is allowed that at least one of the opposing surfaces of plate electrodes 11 and 12, and at least one of the opposing surfaces of plate electrodes 11' and 12' are covered by a dielectric substance.

The edge plane in width direction of a discharge space formed between opposing plate electrodes 11 and 12, and between opposing plate electrodes 11' and 12' (the front plane and the back plane in the drawing) are sealed by cover members 17 and 17'. The cover members prevent such as a gas from transferring between a discharge space and outside of the discharge space.

13 or 13' is a discharge gas introducing inlet to introduce a discharge gas between electrodes 11 and 12, or between electrodes 11' and 12', Each one edge portion in vertical direction of spaces between electrodes 11 and 12, and between electrodes 11' and 12' (the upper portion in the drawing) is utilized as discharge gas inlets 13 and 13'.

In the atmospheric pressure plasma processing apparatus of Fig. 2, parts of the space between electrodes 11 and 12, and electrodes 11' and 12' are utilized as discharge gas inlets 13 or 13', however, a member may be further provided in said space to make a shape of the inlet be able to introduce a discharge gas more efficiently.

14 and 14' are excited discharge gas releasing outlets to release an excited discharge gas, which having been excited between electrodes 11 and 12, and between electrodes 11' and 12', to outside of between electrodes 11 and 12, and of between electrodes 11' and 12', the edge portions (the bottom part of the drawing) opposing to discharge gas introducing inlets 13 and 13', among the spaces between electrodes 11 and 12, and between electrodes 11' and 12', are utilized as excited discharge gas releasing outlet 14 and 14', respectively. Therefore, excited discharge gas outlet 14 and excited discharge gas outlet 14' are arranged on the same side.

In the atmospheric pressure plasma processing apparatus of Fig. 2, parts of the space between electrodes 11 and 12, and electrodes 11' and 12' are utilized as an excited discharge gas releasing outlets 14 and 14', however, a part like a nozzle may be further provided in said space to be able to control such as a releasing degree and a releasing strength when an excited discharge gas, generated between plate electrodes 11 and 12, or between plate electrodes 11' and 12', is released outside.

15 is a thin film forming gas introducing inlet to introduce a thin film forming gas into a space sandwiched by two electrode pairs (between electrodes 12 and 12'), and one of the edge portions (the top part in the drawing) in a vertical direction of electrodes 12 and 12' is utilized as thin film forming gas introducing inlet 15. Herein, thin film forming gas introducing inlet 15 is in the same side as discharge gas introducing inlets 13 and 13'.

In atmospheric pressure plasma processing apparatus of Fig. 2, a part of the space between electrodes 12 and 12' as it is, is utilized as a discharge gas introducing inlet 15, however, a member may be further provided in said space to make a shape of thin film forming gas inlet 15 be able to introduce a thin film forming gas between plate electrodes 12 and 12' more efficiently as well as easily.

16 is a thin film forming gas releasing outlet to release a thin film forming gas having been introduced between electrodes 12 and 12' outside the space sandwiched by electrodes 12 and 12', and the edge portion (the bottom part in the drawing) opposing to thin film forming gas introducing inlet 15 is utilized as thin film forming gas releasing outlet 16. Therefore, thin layer forming gas releasing outlet 16 is at the same side as excited discharge gas introducing inlets 14 and 14'. By employing such a constitution, it is possible to generate an indirectly excited gas in the neighboring outside of thin film forming gas releasing outlet 16.

In the atmospheric pressure plasma processing apparatus of Fig. 2, a part of the space between electrodes 12 and 12', as it is, is utilized as thin film forming gas releasing outlet 16, however, a member like a nozzle may be further provided in said space to control such as a releasing degree and a releasing strength when a thin film forming gas being present between plate electrodes 12 and 12' is released outside.

In the embodiment, space between electrodes 12 and 12' as it is, is utilized as a path for a thin layer forming gas, however, thin layer forming gas introducing inlet 15 and thin layer gas releasing outlet 16 may be connected by such as a tube to make a structure to pass the thin layer forming gas between electrodes 12 and 12'.

In the above constitution, thin film forming gas releasing outlet 16 and excited discharge gas releasing outlets 14 and 14' utilize the same edge portion, in addition to this, provided is a structure in which thin film forming gas releasing outlet 16 is sandwiched by excited discharge gas releasing outlet 14 and excited discharge gas releasing outlet 14'. Therefore, a thin film forming gas released through thin film forming gas releasing outlet 14 and an excited discharge gas released through excited discharge gas releasing outlet 14 are brought into contact at discharge space B formed among thin film forming gas releasing outlet 16, excited discharge gas releasing outlets 14 and 14', and substrate 8 to generate an indirectly excited gas, and a substrate is exposed in this indirectly excited gas resulting in formation of an aimed anti-stain film on the substrate.

Further, employed may be a structure in which the position of the aforesaid flow passage of an excited discharge gas is exchanged with the position of the aforesaid flow passage of a thin film forming gas.

In this embodiment, explained is a structure in which one thin film forming gas releasing outlet is sandwiched by two excited discharge gas releasing outlets, however, possible is a structure in which a plural number of constitutions of an excited discharge gas releasing outlet, a thin layer forming gas releasing outlet, an excited discharge gas releasing outlet and a thin layer forming gas releasing outlet in this order from the edge are arranged, by further adding a pair of plate electrodes to release an excited discharge gas and making the space between said electrodes be a newly prepared thin film forming gas releasing outlet.

5 is a high frequency electric power source to apply a high frequency voltage between electrodes 11 and 12, and electrodes 11' and 12'. 9 is an earth, and electrodes 11 and 11' are grounded by earth 9.

A discharge gas being present between plate electrodes 11 and 12 and plate electrodes 11' and 12' is present under an atmospheric or approximately atmospheric pressure, and is excited to generate an excited discharge gas by applying a voltage by use of high frequency electric power source 5 between plate electrodes 11 and 12, and between electrodes 11' and 12' .

An electrode system utilized in the atmospheric pressure plasma discharge apparatus of Fig. 2 is constituted so as to perform discharge by applying a voltage between electrodes 11 and 12, and between electrodes 11' and 12', and is also able to perform thin film formation on a substrate repeatedly by arranging a plural number of said electrode systems along the substrate transfer direction. Thereby, plural times of film formation having a same composition or different compositions can be performed on substrate 8.

Next a thin film forming method utilizing the atmospheric plasma discharge processing apparatus shown in Fig. 2 will be explained.

A discharge gas is introduced through discharge gas introducing inlets 13 and 13' between electrodes 11 and 12 and between electrodes 11' and 12', and a high frequency voltage is applied by high frequency electric power source 5 to generate an excited discharge gas. Said excited discharge gas is released outside through discharge gas releasing outlets 14 and 14'.

On the other hand, discharge is not caused between electrodes 12 and 12', and a thin film forming gas is introduced through thin film forming gas introducing inlet 15 followed by being released through thin film forming gas releasing outlet 16.

A thin film forming gas released through thin film forming gas releasing outlet 16 is brought into contact with an excited discharge gas released through excited discharge gas releasing outlets 14 and 14' so as to be sandwiched by discharge space B formed among substrate 8 and each gas releasing outlets resulting in being converted into an indirectly excited gas, and substrate 8 is exposed to this indirectly excited gas to form a thin film on substrate 8.

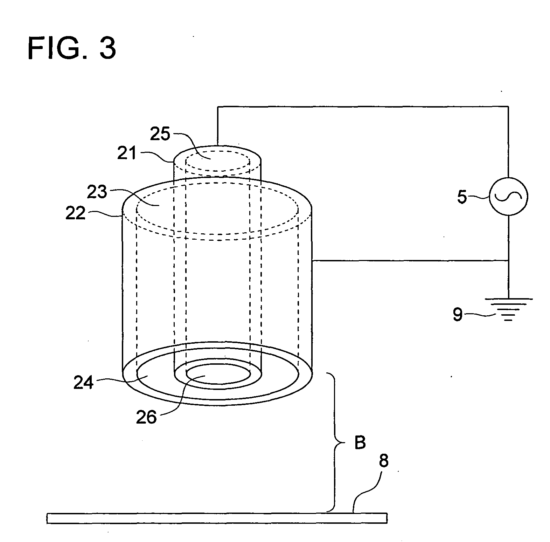

Fig. 3 is an oblique view drawing of another atmospheric pressure plasma discharge processing apparatus.

21 is an inside electrode and 22 is an outside electrode, which constitute a pair of opposing electrodes. Inside electrode 21 and outside electrode 22 each are hollow cylindrical electrodes, and inside electrode 21 is homocentrically arranged in the cylinder of outside electrode 22

In the invention, the opposing surfaces of inside electrode 21 and outside electrode 22 are both covered with a dielectric substance, however, it is acceptable that the opposing surface of either of inside electrode 21 or outside electrode 22 is covered with a dielectric element. Herein, discharge is caused between these opposing planes.

As inside electrode 21 and outside electrode 22 utilized can be electrodes and a dielectric substance which can be utilized for electrodes 11, 12, 11' and 12' which were explained above in Fig. 2.

23 is a discharge gas introducing inlet to introduce a discharge gas, which is one end of a space formed by inside electrode 21 and outside electrode 22.

In the atmospheric pressure plasma processing apparatus of Fig. 3, the top edge part of the space between inside electrode 21 and outside electrode 22 as it is, is utilized as discharge gas introducing inlet 23, however, a member may be further provided in said space to make a shape of discharge gas introducing inlet 23 be able to introduce a discharge gas more efficiently between inside electrode 21 and outside electrode 22.

24 is an excited discharge gas releasing outlet, which is one edge other than that of discharge gas introducing inlet 23, of the space formed with inside electrode 21 and outside electrode 22.

In the atmospheric pressure plasma processing apparatus of Fig. 3, the bottom end of the space formed with inside electrode 21 and outside electrodes 22 as it is, is utilized as an excited discharge gas releasing outlet 24, however, a member like a nozzle may be further provided in said space to control such as a releasing degree and a releasing strength when an excited discharge gas, which has been generated between inside electrodes 21 and outside electrode 22, is released outside.

25 is a thin film forming gas introducing inlet and is one opening (the top edge portion) of the cylinder of inside electrode 21 as thin film forming gas introducing inlet 25. Herein, thin film forming gas introducing inlet 25 utilizes the same side of the electrode cylinder as discharge gas releasing outlet 23.

In the atmospheric pressure plasma processing apparatus of Fig. 3, one top edge of the cylinder of inside electrode 21 as it is, is utilized as thin film forming gas introducing inlet 25, however, a member may be further provided in said space to make a shape of thin film forming gas introducing inlet 25 be able to introduce a thin film forming gas more efficiently into the cylinder of inside electrode 21.

26 is a thin film forming gas releasing outlet and utilizes one end, which is not utilized as thin film forming gas introducing inlet 25, of the cylinder of inside electrode 21. Therefore, thin film forming gas releasing outlet is on the same side as excited discharge gas releasing outlet 14.

In the atmospheric pressure plasma processing apparatus of Fig. 3, one end of the openings of a cylinder of inside electrode 21 as it is, is utilized as thin film forming gas releasing outlet 26, however, a member like a nozzle may be further provided at the opening of said cylinder to control such as a releasing degree and a releasing strength when a thin film forming gas is released outside.

In this embodiment, the cylinder of inside electrode 21, as it is, is utilized as a thin film forming gas passage, however, possible is a structure in which a gas is passed through the cylinder of inside electrode 21 by connecting thin film forming gas introducing inlet 25 and thin film forming gas releasing outlet 26, employing such as a tube.

As described above, thin film forming gas releasing outlet 26 and excited discharge gas releasing outlet 24 are arranged on the same side, and provided is a structure in which thin film forming gas releasing outlet 26 is surrounded by excited discharge gas releasing outlet 24. Therefore, a thin film forming gas released through thin film forming gas releasing outlet 26 is brought into contact with an excited discharge gas released through excited discharge gas releasing outlet 24 in discharge space B formed among substrate 8 and each gas releasing outlet so as to be sandwiched by said excited discharge gas to be converted into an indirectly excited gas, and a thin film is formed on substrate 8 by exposing substrate 8 to said indirectly excited gas.

In this embodiment, explained is a structure in which one thin film forming gas releasing outlet is surrounded by an excited discharge gas releasing outlet, however, possible is a thin film forming apparatus having a structure comprising a plural number of constitutions in which a thin film forming gas releasing outlet, an excited discharge gas releasing outlet, a thin film forming gas releasing outlet and an excited discharge gas releasing outlet in this order from the inside are arranged, by further adding a cylindrical inside electrode and outside electrode in the inside electrode as well as a thin film forming gas releasing outlet and discharge gas releasing outlet in the inside electrode similarly.

The atmospheric pressure plasma processing apparatus of Fig. 3 is constituted of inside electrode 21 and outside electrode 22, between which a voltage is applied by high frequency electric power source 5, however, a plural number of these electrode systems may be arranged along the substrate transfer direction to perform thin film formation on the substrate repeatedly. Thereby, it is possible to perform plural times of film formation on substrate 8 having a same composition or different compositions.

Next, explained will be a thin film forming method employing the atmospheric pressure plasma processing apparatus of Fig. 3.

A discharge gas is introduced through discharge gas introducing inlet 23 between inside electrode 21 and outside electrode 22, and a high frequency voltage being applied by high frequency electric power source 5 to excite the discharge gas, which is released outside through excited gas releasing outlet 24.

On the other hand, a thin film forming gas is introduced through thin film forming gas introducing inlet 25 inside the cylinder of inside electrode 21, and a thin film forming gas is released through thin film forming gas releasing outlet 26. A thin film forming gas released through thin film forming gas releasing outlet 26 is brought into contact with an excited gas released through excited gas releasing outlet 24 in the outside of discharge space B in a state of being surrounded by said excited gas, and substrate 8 is exposed to this indirectly excited gas to form a thin film on substrate 8.

In a thin film forming method of the invention, a substrate also can be exposed to the aforesaid indirectly excited gas after the substrate has been subjected to a prior process by being exposed to a discharge space or an excited discharge gas.

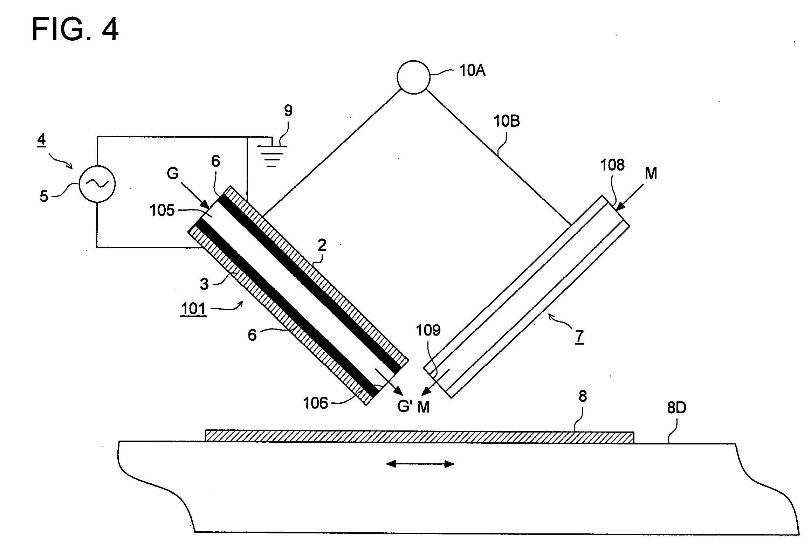

In Fig. 4, an atmospheric pressure plasma discharge processing apparatus is equipped with solid dielectric vessel 101 having first electrode 2 and second electrode 3 opposed to each other. Each surface opposing to first electrode 2 and second electrode 3 is mounted with dielectric substance 6. Solid dielectric vessel 101 has discharge gas introducing inlet 105 and excited discharge gas releasing outlet 106. High frequency electric power source 5, as electric field applying means 4, applies a high frequency electric field between opposing electrodes. The apparatus is equipped with thin film forming gas supplying section 7. A discharge gas is excited by applying a voltage between the opposing electrodes while a discharge gas is flown through solid dielectric vessel 101. And a thin film is formed on substrate 8 by arranging the supply direction of an excited gas and the supply direction of a thin film forming gas to be crossed.

Further, solid dielectric vessel 101 and thin film forming gas supplying section 7 are fixed by movable jig 10 A via holding joint 10B so as to give each arbitrary crossing degree. Further, although not shown in Fig. 4, in addition to above constitutions, the apparatus is constituted of such as a gas supplying means to introduce a discharge gas into solid dielectric vessel 101 as well as a thin film forming gas into thin film forming gas supplying section 7 and electrode temperature control means to control temperature of the aforesaid electrodes.

That a supply direction of an excited discharge gas and a supply direction of a thin film forming gas are crossed, as referred in the invention, means that a degree between a supply direction of an excited discharge gas, that is, solid dielectric vessel 101 and a supply direction of a thin layer forming gas, that is, thin layer forming gas supplying section 7, is in a range of more than 0 degree (parallel) and less than 360 degrees, preferably more than 0 degree (parallel) and not more than 180 degrees and more preferably 15 to 150 degrees, with respect to a mixing efficiency of the both gases.

Further, in a thin film forming apparatus of the invention, to perform the process efficiently with a small amount of processing gas, the region where a releasing direction of the aforesaid excited discharge gas and a releasing direction of a thin film forming gas cross is arranged to be near excited discharge gas releasing outlet 106, and an object to be processed is preferably placed in said crossing region. Further, thin film forming gas releasing outlet 109 is also preferably near to the aforesaid crossing region.

Further, a distance between substrate 8 and aforesaid excited discharge gas releasing outlet 106 is appropriately determined depending on the flow rate of a discharge plasma released through aforesaid excited discharge gas releasing outlet 106, however, is preferably 0.01 to 10.0 cm because probability to contact with air becomes large and a large flow rate is required when the distance is too large.

In the embodiment, it is preferable that a solid dielectric vessel and the aforesaid thin film forming gas supplying section are connected by a movable jig so that said solid dielectric vessel and said thin film forming gas supplying section are transferable while keeping approximately a constant relative position.

A discharge space is a region being sandwiched by first electrode 2 and second electrode 3 and provided with dielectric substance 6. Discharge gas G is introduced into the discharge space through discharge gas introducing inlet 105 to be excited. Further, thin film forming gas M containing an organometallic compound with an organic group containing a fluorine atom is introduced into thin film forming gas supplying section 7 through thin film forming gas introducing inlet 108. Successively, excited discharge gas G' through excited discharge gas releasing section 106 of solid dielectric vessel 101 and thin film forming gas M through thin film forming gas releasing outlet 109 of thin film forming gas supplying section 7 are released under a crossing condition, and the surface of substrate 8 is exposed thereto to form a thin film. Herein, as substrate 8 processed can be not only a sheet-form object to be processed like a support but also objects having various sizes and forms. A thin film can be formed, for example, also on objects, such as of a lens-form and a spherical-form, having a thickness.

In the invention, a thin film exhibiting excellent water-repellency, oil-repellency, a wiping-off property of sebum and ink and repeating durability thereof as well as superior abrasion resistance can be prepared by utilizing an organometallic compound with an organic group containing a fluorine atom as well as bringing an excited gas and a thin film forming gas into contact in a state of crossing.

A pair of opposing electrodes (first electrode 2 and second electrode 3) is constituted of a metallic base material and dielectric substance 6, which are similar to those explained in Figs. 1 to 3.

As opposing electrodes, utilized may be a plate electrode as shown in Fig. 4, and utilized may be also a hollow cylindrical electrode or a square pole electrode for one or both of the electrodes. One of the electrodes (second electrode 3) is connected to high frequency electric power source 5 and another electrode (first electrode 2) is grounded by earth 9, so that an electric field can be applied between the electrodes. On the other hand, also possible is a constitution in which voltage is applied on first electrode 2 and other second electrode 3 is grounded.

High frequency electric power source 5 as electric field applying means 4 is similar to those explained in Figs. 1 to 3.

A high frequency electric field applied between opposing electrodes may be comprised of either pulse waves or continuous sine waves. In the case of applying an electric field of a pulse-form, an example of a pulse electric field wave type includes wave types of an impulse-type, a pulse-type and a modulation-type. The shorter is the rise time of a pulse, more efficiently performed is ionization of a gas, although the wave-type is not limited thereto. The rise time is preferably not longer than 100 µs. Further modulation may be performed by utilizing a pulse having a different pulse wave form, rise time or frequency number. Such modulation is efficient for performing a high speed continuous surface treatment.

Further, in the embodiment, it is preferred that a substrate transferring device is provided, and a substrate mounted on said substrate transferring device is transferred to the neighborhood of the aforesaid excited discharge gas supplying section to be exposed to an excited discharge gas. 8D shown in Fig. 4 is a substrate transferring device, which is transferred in an arbitrary direction while holding the substrate thereon.

In a thin film formed substance prepared by a thin layer forming method of the invention, a surface specific resistance of a thin film surface formed on an object to be processed is preferably not more than 1 x 10¹² Ω/□.

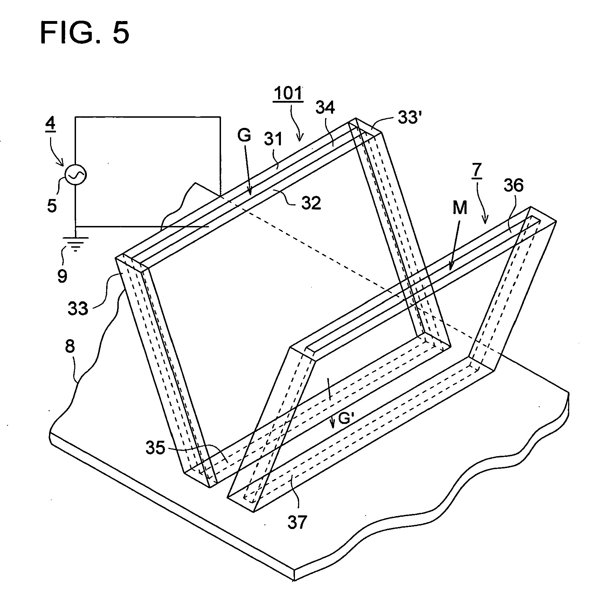

Fig. 5 is an oblique view drawing of the atmospheric pressure plasma discharge processing apparatus being shown in Fig. 4 and useful for the invention.

The atmospheric pressure plasma discharge processing apparatus shown of Fig. 5 is provided with an excited discharge gas releasing outlet and a thin film forming gas releasing outlet over almost the whole width range of an object to be covered with a thin film and is an apparatus capable of forming a thin film continuously in a state that a solid dielectric vessel and a thin layer forming gas supplying section are fixed.

In Fig. 5, solid dielectric vessel 101 is provided with plate electrodes 31 and 32 each of which has a same size of a rectangular form, plate electrode 31 and plate electrode 32 each constitute opposing electrodes. A pair of opposing electrodes is arranged parallel. Further each plate electrode is arranged while the four corners coincide. A dielectric substance (being not shown in the drawing) covers each opposing surface of plate electrodes 31 and 32. It is acceptable that the opposing surface of at least one of plate electrodes 31 and 32 is covered with a dielectric substance.

The end planes in the width direction of a discharge space formed between plate electrodes 31 and 32 (the front side plane and the back side plane in the drawing) are sealed by cover members 33 and 33'. The cover members prevent such as gases from transferring between a discharge space and the outside of the discharge space.

34 is a discharge gas introducing inlet to introduce discharge gas G between plate electrodes 31 and 32.

In the atmospheric pressure plasma processing apparatus of Fig. 5, a part of the space between electrodes 31 and 32 as it is, is utilized as discharge gas introducing inlet 34, however, a member may be further provided in said space to make a shape of discharge gas introducing inlet 34 be able to introduce a discharge gas between plate electrodes 31 and 32 more efficiently as well as easily.

35 is an excited discharge gas releasing outlet.

Thin film forming gas supplying section 7 includes a structure basically similar to that of aforesaid solid dielectric vessel 101 and, for example, is of a rectangular form provided with an introducing passage of a slit-form for thin film forming gas M, therein. 36 is a thin film forming gas introducing inlet to introduce thin film forming gas M, and thin film forming gas M introduced supplied on the surface of substrate 8, in a state of crossing with the aforesaid excited discharge gas, to form an aimed anti-stain film on the substrate.

Thin film forming gas releasing outlet 37 is an edge portion (the bottom part in the drawing) opposite to thin film forming gas introducing inlet 36. Possible is a structure in which a plural sets of an excited discharge gas releasing outlet and a thin film forming gas releasing outlet are arranged.

5 is a high frequency electric power source to supply a high frequency electric field between plate electrodes 31 and 32. 9 is an earth.

A discharge gas being present between plate electrodes 31 and 32 is applied with an electric field under an atmospheric or approximately atmospheric pressure resulting in the discharge gas being excited.

A plural number of electrode systems utilized in the atmospheric pressure plasma discharge processing apparatus of Fig. 5 can be arranged along the substrate transfer direction to perform thin film formation on the substrate repeatedly. Thereby, performed can be a plural of film formation comprising a same component or different components.

Next, a thin film forming method employing the atmospheric pressure plasma discharge processing apparatus shown in Fig. 5 will be explained.

Discharge gas G is introduced through discharge gas introducing inlet 34 between plate electrodes 31 and 32 and is excited under an atmospheric or approximately atmospheric pressure to generate an excited discharge gas G'. Excited discharge gas G' is released outside through discharge gas releasing outlet 35.

On the other hand, thin film forming gas M is introduced through thin layer forming gas introducing inlet 36 and released outside through thin film forming gas releasing outlet 37.

Herein, although not shown in Fig. 5, as explained in Fig. 4, solid dielectric vessel 101 and thin film forming gas supplying section are fixed by a movable jig via a holding joint so that each gives an arbitrary crossing degree.

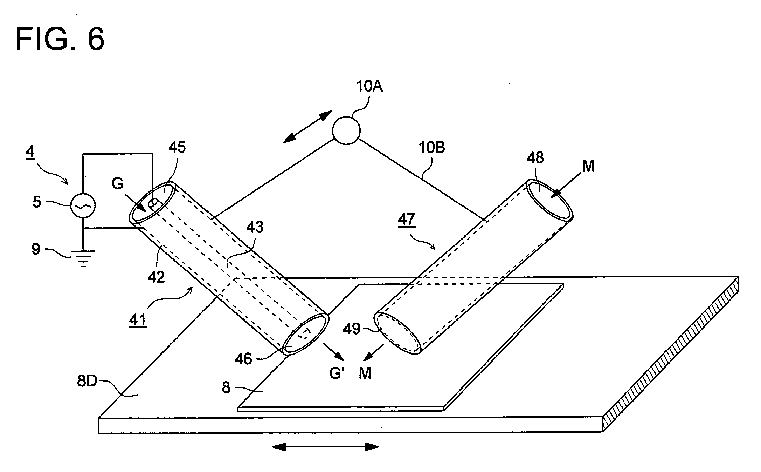

Fig. 6 is an oblique view drawing to show an example of another atmospheric pressure plasma discharge processing apparatus which can be utilized in the invention.

43 is an inside electrode, and 42 is an outside electrode, which form a pair of electrodes opposing to each other. Outside electrode 42 is a hollow cylindrical electrode and inside of which inside electrode 43 is monocentrically arranged.

Both of the opposing surfaces of inside electrode 43 and outside electrode 42 may be covered with a dielectric substance or the surface opposing to either one of inside electrode 43 and outside electrode 42 may be covered with a dielectric substance. And discharge is caused between the opposing surfaces.

The electrode and dielectric substance which are explained in Fig. 4 can be utilized for inside electrode 43 and outside electrode 42.

45 is a discharge gas introducing inlet to introduce discharge gas G between inside electrode 43 and outside electrode 42. A discharge space is formed between inside electrode 43 and outside electrode 42. Further, discharge gas introducing inlet 45 utilizes one end of the space formed with inside electrode 43 and outside electrode 42.

In the atmospheric pressure plasma discharge processing apparatus of Fig. 6, discharge gas introducing inlet 45 utilizes the top portion of the space formed with inside electrode 43 and outside electrode 42 as it is, however, a member may be further provided in said space to make a shape of discharge gas introducing inlet 45 be able to introduce a discharge gas efficiently and easily.

46 is an excited discharge gas releasing outlet and utilizes the bottom end portion, which is not utilized as discharge gas introducing inlet 45, of the space formed with inside electrode 43 and outside electrode 42.

A plural number of an electrode system utilized in the atmospheric pressure plasma discharge processing apparatus of Fig. 6 may be provided along the substrate transferring direction and thin film formation on a substrate can be also performed repeatedly.

Next, a thin film forming method utilizing the atmospheric pressure plasma discharge processing apparatus of Fig. 6 will be explained.

Discharge gas G is introduced through discharge gas introducing inlet 45 between inside electrode 43 and outside electrode 42, and a discharge gas is excited by being applied with a high frequency electric field by use of high frequency electric power source 5 under atmospheric pressure or approximately atmospheric pressure to generate excited discharge gas G'. Excited discharge gas G' is released outside through excited gas releasing outlet 46.

On the other hand, thin film forming gas supplying section 7 provided with a hollow cylindrical structure, introduces thin film forming gas M through thin film forming gas introducing inlet 48 and releases thin film forming gas M through thin film forming gas releasing outlet 49, and thin film forming gas M released through thin film forming gas outlet 49 is mixed with excited discharge gas G' released through excited discharge gas releasing outlet 46 in a state of crossing each other on substrate 8, resulting in formation of a thin film on substrate 8.

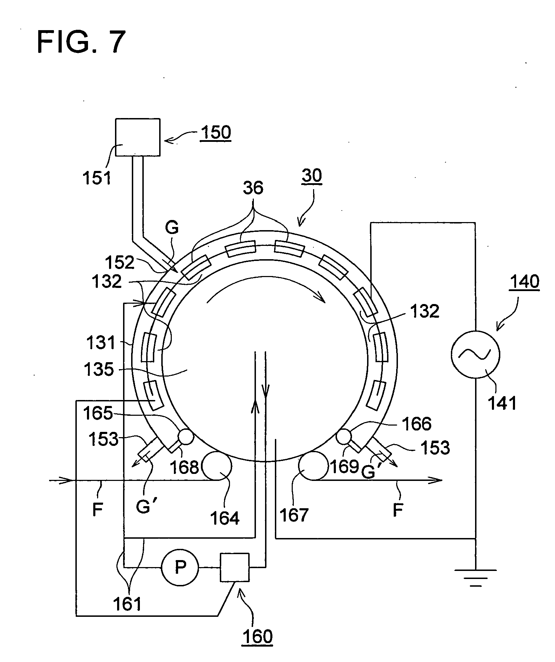

Fig. 7 is a brief drawing to show an example of an atmospheric pressure plasma discharge processing apparatus utilized for a pre-treatment according to the invention. Fig. 7 is constituted of plasma discharge processing apparatus 130, gas supplying means 150, voltage applying means 140 and electrode temperature controlling means 160. Substrate F is subjected to a plasma discharge treatment between roll rotating electrode 135 and prismatic fixed electrode group 136. Roll rotating electrode 135 is an earth electrode and prismatic electrode group 136 is a voltage applying electrode being connected to high frequency electric power source 141. Substrate F is transferred, by being wound on roll rotating electrode 135 while being kept to contact thereon, between said roll rotating electrode and prismatic electrode group 136, and is transferred to a thin film forming process according to the invention as the next process. Next, gas supplying means 150 will be explained. Gas G generated in gas generating device 151 is introduced after adjusting the flow rate through supplying inlet 152 into plasma discharge processing vessel 131 comprising spaces between opposing electrodes (being utilized as a discharge space) 132, said plasma discharge vessel 131 being filled with gas G, and exhaust gas G' after having been discharge processed is exhausted through exhausting outlet 153. Next, voltage applying means 140 will be explained. A voltage is applied to prismatic fixed electrode group 136 by high frequency electric power source 141, and a discharge plasma is generated between said prismatic fixed electrode group 136 and roll rotating electrode 136 as an earth electrode. A medium being heated or cooled is sent to the electrodes by use of electrode temperature controlling means 160 for roll rotating electrode 135 and prismatic electrode group 136. A medium, of which temperature having been controlled with electrode temperature controlling means 160, is sent by use of a liquid sending pump to roll rotating electrode 135 and prismatic electrode group 136 via piping 161 to control the temperature from the inside thereof. It is preferable to control the temperature because physical properties and compositions of a thin film prepared may vary depending on the temperature of a substrate at the time of plasma discharge process. As a medium preferably utilized are insulating materials such as distilled water and oil. At the time of plasma discharge processing, it is preferable to control the inside temperature of roll rotating electrode 135 so as to cause temperature roughness of a substrate within the width direction and longitudinal direction as little as possible. Herein, 168 and 169 are partition plates to separate plasma discharge processing vessel 131 from external environment.

Further, in a thin film forming method of the invention, a substrate surface on which a thin film is formed preferably contains an inorganic compound, or the primary component of a substrate surface is preferably a metal oxide.

An atmospheric pressure plasma discharge apparatus such as shown in Fig. 7 can be utilized for one of pre-processes to prepare the aforesaid constitution on a substrate surface.

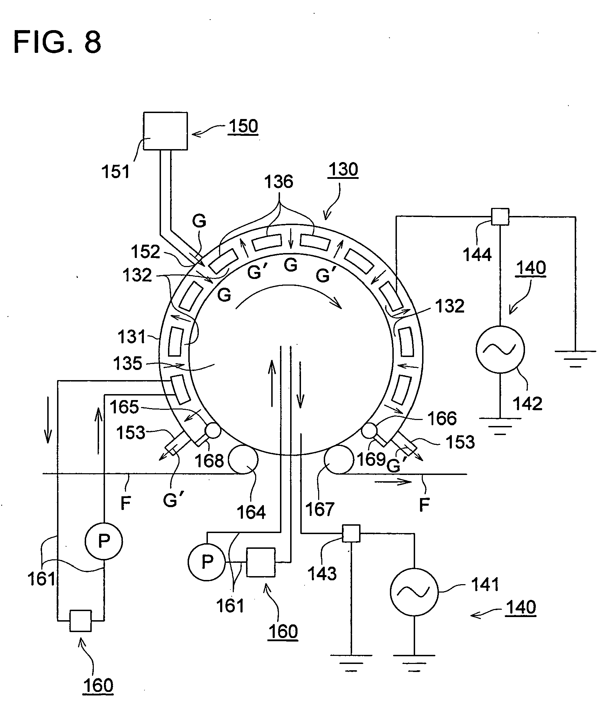

As an atmospheric pressure plasma discharge apparatus, an apparatus similar to that explained in Fig. 7 can be utilized in the case of employing a discharge gas comprising helium or argon as the primary component, while the atmospheric pressure plasma discharge apparatus shown in Fig. 8 can be utilized more preferably in the case of employing a discharge gas comprising nitrogen as the primary component

Fig. 8 is an outline drawing to show an example of an atmospheric pressure plasma discharge apparatus utilized for a surface treatment of a substrate, according to the invention.

The outline of the apparatus is similar to the constitution shown in Fig. 7, however, in discharge space 132 between roll rotating electrode 135 and prismatic electrode 136, high frequency voltage V₁ having a frequency number of ω₁ is applied to roll rotating electrode (the first electrode) 135 from first electric power source 141, and high frequency voltage V₂ having a frequency number of ω₂ is applied to prismatic electrode (the second electrode) 136 from second electric power source 142.

First filter 143 is arranged between roll rotating electrode (the first electrode) 135 and first electric power source 141 to make electric current from first electric power source 141 flow towards roll rotating electrode 135. Said first filter is designed to easily earth a current from second electric power source 142. Further, second filter 144 is arranged between prismatic electrode (the second electrode) 136 and second electric power source 142 to make electric current from second electric power source 142 flow towards the second electrode. The second filter 144 is designed to easily earth a current from first electric power source 141.

Herein, roll rotating electrode may be utilized as the second electrode and prismatic electrode as the first electrode. In either case, first electric power source is connected to the first electrode and the second electric power source is connected to the second electrode. A high frequency voltage having a voltage higher than that to the second electrode (V₁ > V₂) is applied to the first electrode, and their frequency numbers satisfy ω₁ < ω₂.

### EXAMPLES

### [Example 1]

In the following, the invention will be more specifically explained in reference to examples, however, the invention is not limited thereto.

### <Preparation of Thin Film (Anti-Stain Film) Formed Substance>

### [Preparation of Substrate]

### (Formation of Anti-Static Layer)

The following coating composition of anti-static layer 1 was coated by means of die coating on the one side surface of cellulose triacetate film (Konica Tac KC 80UVSF, manufactured by Konica Corp.) having a thickness of 80 µm to make a dry layer thickness of 0.2 µm, followed by being dried at 80 °C for 5 minutes to prepare a anti-static layer.

### <Coating Composition of Anti-Static Layer>

| | |
|---|---|
| Dianal (BR-88, manufactured by Mitsubishi Rayon Co., Ltd.) | 0.5 weight parts |
| Propyreneglycol monomethylether | 60 weight parts |
| Methyl etyl ketone | 15 weight parts |
| Ethyl lactate | 6 weight parts |
| Methanol | 8 weight parts |
| Electric conductive polymer resin IP-16 (described in JP-A No. 9-203810) | 0.5 weight parts |

### (Preparation of Hard-Coat Layer)

The following hard-coat layer composition was coated on the film having been coated with the above anti-static layer so as to make a dry layer thickness of 3.5 µm, followed by being dried at 80 °C for 5 minutes. Next, the coated layer was cured by irradiation with a high pressure mercury lamp of 80 W/cm for 4 seconds at a distance of 12 cm to prepare a hard coat film provided with a hard coat layer. A refractive index of the hard coat layer was 1.50.

### <Hard-Coat Layer Composition>

| | |
|---|---|
| Dipentaerythritol hexaacrylate monomer | 60 weight parts |
| Dipentaerythritol hexaacrylate dimmer | 20 weight parts |
| Dipentaerythritol hexaacrylate trimer or more polymeric component | 20 weight parts |
| Diethoxybenzophenone (UV photo-initiator) | 2 weight parts |
| Methyl ethyl ketone | 50 weight parts |
| Ethyl acetate | 50 weight parts |
| Isopropyl alcohol | 50 weight parts |

Above composition was dissolved while stirring.

### <Coating of Back-Coat Layer>

The following back-coat layer coating composition was coated by use of a gravure coater on the surface opposite to the surface on which the aforesaid hard-coat layer having been coated to make a wet layer thickness of 14 µm followed by being dried at 85 °C to prepare a back-coat layer.

### <Back-coat Layer Coating Composition>

| | |
|---|---|
| Acetone | 30 weight parts |
| Ethyl acetate | 45 weight parts |
| Isopropyl alcohol | 10 weight parts |
| Cellulose diacetate | 0.5 weight parts |
| Aerosil 200V | 0.1 weight parts |

### (Preparation of Anti-Reflection Layer)

Four sets of the atmospheric pressure plasma discharge processing apparatus shown in Fig. 8 were connected and the electrode gap of two electrodes of each apparatus is set to 1 mm, the following gas was supplied into a discharge space of each apparatus to form thin films successively on the hard-coat layer prepared above. In each apparatus, a high frequency voltage of 10 kV/mm having an output power density of 1 W/cm² was applied to the first electrode by use of High Frequency Electric power source produced by Shinnko Denki Co., Ltd. (50 kHz) as the first high frequency electric power source, as well as a high frequency voltage of 0.8 kV/mm having an output power density of 5.0 W/cm² was applied to the second electrode by use of High Frequency Electric power source produced by Pearl Industrial Co., Ltd. (13.56 MHz) as the second high frequency electric power source, respectively in each apparatus, and plasma discharge was performed to prepare anti-reflection layers comprising titanium oxide and silicon oxide as a primary component respectively. A discharge starting voltage of a nitrogen gas in a discharge space of each apparatus was 3.7 kV/mm. Herein, the following thin film forming gas, which had been vaporized into a nitrogen gas by use of a vaporizer, was supplied into a discharge space while being heated. Further, a roll electrode was rotated synchronously with transfer of cellulose ester film by use of a drive. The both electrodes were controlled and heated to make their temperature of 80 °C

### <Titanium Oxide Layer Forming Gas Composition>

| | |
|---|---|
| Discharge gas: Nitrogen | 97.9 weight% |
| Thin film forming gas: Tetraisopropoxy titane | 0.1 weight% |
| Addition gas: Hydrogen | 2.0 weight% |

### <Silicon Oxide Layer Forming Gas Composition>

| | |
|---|---|
| Discharge gas: Nitrogen | 98.9 weight% |
| Thin film forming gas: Tetraethoxy silane | 0.1 weight% |
| Addition gas: Oxygen | 1.0 weight% |

A titanium oxide layer, a silicon oxide layer, titanium oxide layer and silicon oxide layer were provided in this order on the aforesaid hard-coat layer to prepare a substrate (being referred to as TAC in Table 1) having an anti-static layer, a hard-coat layer and an anti-reflection layer. Herein, each layer constituting the anti-reflection layer has a refractive index of 2.1 (a layer thickness of 15 nm), a refractive index of 1.46 (a layer thickness of 33 nm), a refractive index of 2.1 (a layer thickness of 120 nm) and a refractive index of 1.46 (a layer thickness of 76 nm), respectively.

### [Preparation of Sample 1]

### (Atmospheric Pressure Plasma Discharge Processing Apparatus)

An anti-stain layer was formed on the substrate constituted of a hard-coat layer and an anti-reflection layer on the film prepared above by use of an atmospheric pressure plasma discharge processing apparatus shown in Fig. 2. Following gas type A was used as a discharge gas introduced through discharge gas introducing inlets 13 and 13', and gas type B was used as a thin film forming gas introduced through thin film forming gas introducing inlet 15.

### <Gas Type A: Discharge gas>

| | |
|---|---|
| Argon gas | 98.5 weight% |
| Hydrogen gas | 1.5 weight% |

### <Gas Type B: Thin film forming gas>

| | |
|---|---|
| Argon gas | 99.8 weight% |
| Organometallic compound (Example compound 15) | 0.2 weight% |

(Example compound 15 was vaporized into an argon gas by use of a vaporizer produced by STEC Co., Ltd.)

### <Electrode>

As for electrodes 11, 12, 11' and 12', utilized are electrodes comprising stainless steel SUS 316, the surface of which constituting discharge space further having been covered with alumina ceramics, and the electrode surface constituting a discharge space was fusing covered to make alumina ceramics of 1 mm thick. After a coating solution in which alkoxy silane monomer had been dissolved was coated on the alumina ceramic coat layer followed by being dried, a sealing treatment was performed by being heated at 150 °C to prepare a dielectric substance. Connection to high frequency electric power source 5 and grounding to earth 9 were performed at the portion of electrodes where a dielectric substance is not covered. Herein, a distance between a gas outlet and a substrate was 10 mm.

High Frequency Electric power source, produced by Pearl Industrial Co., Ltd. (frequency number: 13.56 MHz) was employed as high frequency electric power source 5 to supply a discharge electric power.

### <Thin Film Formation>

A thin film forming gas (gas type A) and a discharge gas (gas type B) supplied were brought into contact with each other after having been released through each gas releasing outlet, that is, outside the discharge space, to be converted into an indirectly excited gas, and a film substrate is exposed to said indirectly excited gas to form a thin film on the substrate surface, resulting in preparation of sample 1. At this time, the substrate was transferred along the perpendicular direction against the thin film forming gas releasing degree. This transfer was performed by scanning in the right and left directions of the drawing. Further, gas type A and gas type B were utilized at a ratio of 1/1 based on a volume amount.

### [Preparation of Samples 2 to 9]

Samples 2 to 9 were prepared in a similar manner to preparation of sample 1 described above, except that each organometallic compound described in Table 1 was utilized instead of exemplary compound 15 used as a raw material of gas type B.

### [Preparation of Sample 10]

Sample 10 was prepared in a similar manner to preparation of aforesaid sample 1, except that the substrate was subjected to the following treatment before being exposed to an indirectly excited gas.

Pre-treatment A: Before exposing a substrate to an indirectly excited gas, "an argon gas"/"an oxygen gas" = 99/1 (based on a volume ratio) as a discharge gas was introduced into the discharge space constituted of first electrode 2 and second electrode 3 being arranged so as to oppose each other, and a substrate was exposed to the indirectly excited gas for 1 second. Herein, High Frequency Electric power source, produced by Pearl Industrial Co., Ltd. (frequency number: 13.56 MHz) was utilized at a discharge output power of 10 W/cm² as a high frequency electric power source.

### [Preparation of Sample 11]

Sample 11 was prepared in a similar manner to preparation of aforesaid sample 1, except that a substrate was subjected to following treatment B before being exposed to an indirectly excited gas.

Pre-treatment B: Before exposing a substrate to an indirectly excited gas, it was exposed to the discharge space, where "an argon gas"/"an oxygen gas" = 99/1 (based on a volume ratio) as a discharge gas was introduced, for 5 seconds, utilizing the discharge apparatus comprising a pair of roll electrodes, the gap distance of which was 1 mm, shown in Fig. 4. Herein, a voltage was applied to the second electrode at an output power density of 5.0 W/cm² by use of High Frequency Electric power source, produced by Pearl Industrial Co., Ltd. (frequency number: 13.56 MHz) as a high frequency electric power source.

### [Preparation of Sample 12]

Sample 12 was prepared in a similar manner to preparation of aforesaid sample 1, except that sheet glass (Product name: 0.5t Soda Glass, one-side polished type, manufactured by Nippon Sheet Glass Co., Ltd.) was employed instead of cellulose ester film as a substrate.

### [Preparation of Sample 13]

Sample 13 was prepared in a similar manner to preparation of aforesaid sample 1, except that an argon gas used in a thin film forming gas (gas type A) and a discharge gas (gas type B) were replaced by a nitrogen gas respectively, and that discharge was performed by use of High Frequency Electric power source, produced by HAIDEN LABOLATORY (frequency number: 40 kHz) as a high frequency electric power source, at a discharge output power of 6 W/cm².

### [Preparation of Samples 14 and 15]

Samples 14 and 15 were prepared in a similar manner to preparation of aforesaid sample 1, except that each organometallic compound described in Table 1 was utilized instead of an exemplary compound 15 utilized as a raw material for gas type B.

### [Preparation of Sample 16: Comparative Example]

A coating solution comprising exemplary compound 15 diluted with isopropyl alcohol was coated by means of a bar coating method on a substrate provided with an anti-static layer, a hard-coat layer and an anti-reflection layer prepared above so as to make a wet layer thickness of 15 µm, followed by being dried at 90 °C for 5 hours to prepare comparative sample 16.

### [Preparation of Sample 17: Comparative Example]

Comparative sample 17 was prepared in a similar manner to preparation of aforesaid sample 1, except that 6-fluoropropylene was utilized instead of an exemplary compound 15 utilized as a raw material of gas type B.

### [Preparation of Sample 18: Comparative Example]

Comparative sample 18 was prepared in a similar manner to preparation of aforesaid sample 1, except that methylethoxy silane was utilized instead of an exemplary compound 15 utilized as a raw material of gas type B.

### [Preparation of Sample 19: Comparative Example]

Sample 19 was prepared in a similar manner to preparation of aforesaid sample 1, except that a voltage was applied to the second electrode at an output power density of 0.5 W/ cm² by use of High Frequency Electric power source, produced by Shinko Denki Co., Ltd. (50 kHz) as a high frequency electric power source, and that a gas was supplied after gas type A and gas type B having been mixed before a substrate was exposed to a discharge space.

Primary features of each thin film forming method is shown in Table 1.

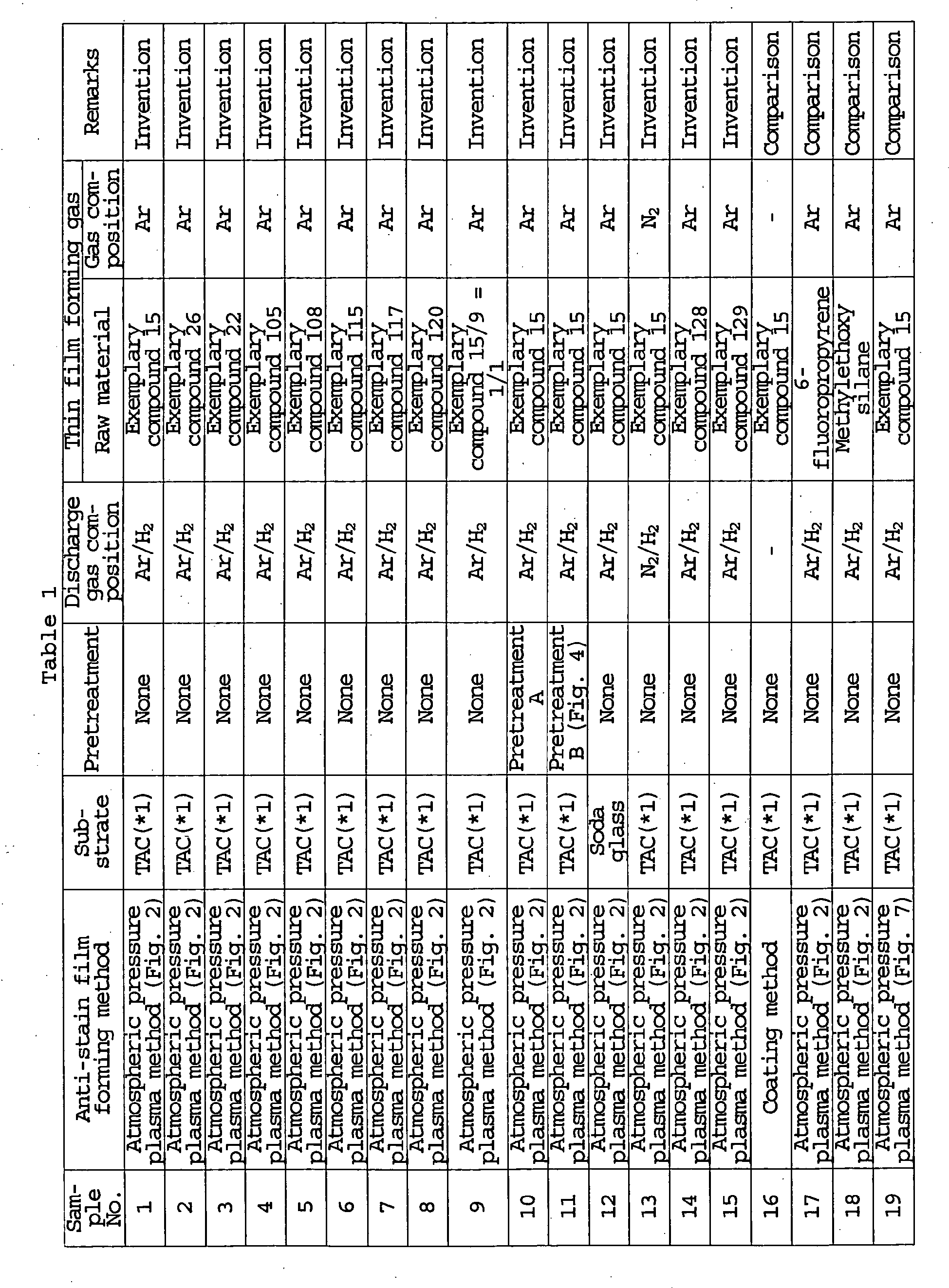

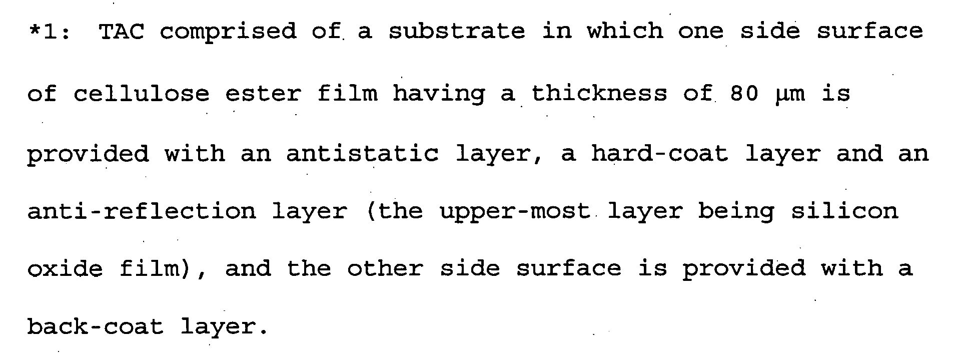

### <Measurement of Characteristic Values and Evaluations of Each Sample>

### [Measurement of Contact Angle]

A contact angle of an anti-stain layer against water as well as against hexadecane was measured by use of Contact Angle Meter CA-W, produced by Kyowa Surface Chemistry Co., Ltd., under an environment of 23 °C and 55% RH. Herein, the measurement was performed randomly with respect to 10 points, an average value of which was determined.

### [Evaluation of Writability with Oil-Based Ink: Evaluation of Oil-Repellency]

After the sample surface of 3 mmφ had been opaqued employing an oil-based ink (Macky Ultra Fine Black MO-120-MC-BK, manufactured by Zebra Co., Ltd.), the written condition on the surface was visually observed to be evaluated and evaluation of writability with oil-based ink was performed according to the following criteria.
A: The surface repels oil-based ink extremely well resulting in being hardly opaqued, and exhibits superior oil-repellency.
B: The surface partly repels oil-based ink resulting in being not uniformly opaqued, and is provided with oil-repellency.
C: The surface shows good affinity for oil-based ink resulting in good writability, and is provided with no oil-repellency.

### [Evaluation of Wipeing-Off Property]

After the sample surface of 3 mmφ had been opaqued employing an oil-based ink (Macky Ultra Fine Black MO-120-MC-BK, manufactured by Zebra Co., Ltd.), the oil-based ink image was wiped-off with soft cloth (BEMCOT M-3, 250 mm x 250 mm, manufactured by Asahi Chemical Industry Co., Ltd.), and this operation was repeated 20 times in the same position. The residual state of oil-based ink was visually observed with respect to after 1 time wiping-off and 20 times wiping-off to evaluate an oil-based ink wiping-off property according to the following criteria.
A: Oil-based ink was completely wiped off.
B: Oil-based ink was mostly wiped off.
C: Oil-based ink was partly remained without being wiped off.

### [Evaluation of Abrasion Resistance]

Each sample surface was scrubbed 10 times by use of steel wool of Bonstar #0000 baring a 500 g weight, and scratches generated were counted visually to perform evaluation according to the following criteria.
A: No scratches are generated.
B: The number of scratches generated is 1 - 4.
C: The number of scratches generated is 5 - 14.
D: The number of scratches generated is not less than 15.

### [Measurement of Surface electrical resistance]

As a result of measuring a surface electrical resistance with respect to thin film substances of the invention according to the following method, all of them were not more than 1 x 10¹² Ω/□.

### (Measurement Method of Surface electrical resistance)

It was measured after samples had been rehumidified under an environment of 23 and 55 %RH for 24 hours by use of Teraohom Meter Model VE-30, produced by Kawaguchi Denki Co., Ltd. An electrode employed in the measurement was comprised of two electrodes (the portion to contact a sample was 1 cm x 5 cm) being arranged at an interval of 1 cm, and the measurement was performed while a sample was brought into contacted with the electrode. The five times of the measured value was designated as a surface electrical resistance (Ω/□).

The results obtained above except a surface electrical resistance are shown in Table 2.

**Table 2**

| Sample No. | Contact angle | | Oil-based ink writability | Oil-based ink wiping-off property | | Abrasion resistance tance | Remarks |
|---|---|---|---|---|---|---|---|
| | Water | Hexadecane | | 1st time | 20th time | | |
| 1 | 112 | 73 | A | A | B | A | Invention |
| 2 | 103 | 68 | B | B | B | A | Invention |
| 3 | 110 | 74 | A | A | B | A | Invention |
| 4 | 104 | 63 | B | B | B | A | Invention |
| 5 | 110 | 70 | A | A | B | A | Invention |
| 6 | 105 | 68 | B | B | B | B | Invention |
| 7 | 104 | 67 | B | B | B | B | Invention |
| 8 | 108 | 65 | B | B | B | A | Invention |
| 9 | 112 | 70 | A | A | B | A | Invention |
| 10 | 114 | 74 | A | A | A | A | Invention |
| 11 | 115 | 76 | A | A | A | A | Invention |
| 12 | 111 | 72 | A | A | B | A | Invention |
| 13 | 112 | 72 | A | A | A | A | Invention |
| 14 | 113 | 68 | A | A | B | A | Invention |
| 15 | 112 | 65 | A | A | B | A | Invention |
| 16 | 104 | 66 | B | B | C | C | Comparison |
| 17 | 98 | 50 | C | C | C | D | Comparison |
| 18 | 90 | 32 | C | B | C | C | Comparison |
| 19 | 93 | 37 | C | B | C | C | Comparison |

It is clear from Table 2 that samples in which an organometallic compound with an organic group containing a fluorine atom was contained as a thin film forming gas raw material and an anti-stain film was prepared according to the invention, compared to comparative examples, are excellent in water-repellency, oil-repellency and an oil-based ink wiping-off property, as well as are superior in abrasion resistance of an anti-stain film formed. Further, it is also clear by comparing sample 13 and sample 1, that an oil-based ink wiping-off property is improved by replacing an argon, which is utilized in a discharge gas and a thin film forming gas, with a nitrogen gas.

### [Example 2]

### [Preparation of Sample 21]

### (Atmospheric Pressure Plasma Discharge Processing Apparatus)

An anti-stain film was formed on substrate 1, provided with a hard-coat layer and an anti-reflection layer on cellulose triacetate film having been prepared in example 1, by use of the atmospheric pressure plasma discharge processing apparatus of Fig. 5. Following gas type A was utilized as a discharge gas introduced through discharge gas introducing inlet 34, and gas type B was utilized as a thin film forming gas introduced through thin film forming gas introducing inlet 36.

### <Gas Type A: Discharge Gas>

| | |
|---|---|
| Argon gas | 98.5 weight% |
| Hydrogen gas | 1.5 weight% |

### <Gas Type B: Thin Film Forming Gas>

| | |
|---|---|
| Argon gas | 99.8 weight% |
| Organometallic compound (Exemplary compound 15) | 0.2 weight% |

(Exemplary compound 15 was vaporized into an argon gas by use of Vaporizing Device, produced by STEC Co., Ltd.)

### <Electrode>

Electrodes 31 and 32 were constituted of an electrode material of stainless steel SUS 316. After the surface of which constituting a discharge space was fusing covered with alumina ceramics of 1mm thick, a coating solution in which alkoxy silane monomer having been dissolved in an organic solvent was coated on the alumina ceramic film followed by being dried, and the coated material was subjected to a sealing treatment by being heated at 150 °C to prepare a dielectric member. Connection to high frequency electric power source 5 and grounding to earth 9 were performed at the portion of the electrode where a dielectric substance was not covered. Herein, the distance between excited discharge gas releasing outlet 5 and the substrate was 10 mm.

Discharge electric power of 5 W/cm2 was applied by use of High Frequency Electric power source, produced by Pearl Industrial Co., Ltd. (frequency number: 13.56 MHz) as high frequency electric power source 5. Herein, the wave form was a sine wave.

### <Thin Film Formation>

A thin film forming gas (gas type B) and a discharge gas (gas type A) supplied were crossed at 90 degrees and mixed on an object to be processed to form a thin film on the substrate resulting in preparation of sample 21. At this time, an object to be processed was arranged to be horizontal and at 45 degrees against a thin film forming gas releasing degree. Further, the object to be processed was reciprocated in left and right directions and also a direction crossing thereto (in the transfer direction of an object to be processed) in Fig. 4. Further, gas type B and gas type A were utilized at a ratio of 1/1 based on the volume.

### [Preparation of Samples 22 to 31]

Samples 22 to 31 were prepared in a similar manner to above sample 21, except that each organomatallic compound described in Table 3 was utilized instead of exemplary compound 15 as a raw material of gas type B.

### [Preparation of Sample 32]

Samples 32 was prepared in a similar manner to aforesaid sample 21, except that a discharge electric power having a pulse electric field of 6.4 kV, a frequency number of 6.1 kHz and a pulse width of 180 µm was applied by frequency electric power source 5.

### [Preparation of Sample 33]

Samples 33 was prepared in a similar manner to aforesaid sample 21, except that an argon gas being utilized as a thin film forming gas (gas type B) and a discharge gas (gas type A) were replaced by a nitrogen gas respectively, and, further, discharge was performed at a discharge electric power of 6 W/cm², by use of High Frequency Electric power source, produced by HAIDEN LABOLATORY (frequency number: 40 kHz), to prepare sample 33.

### [Preparation of Sample 34]

Sample 34 was prepared in a similar manner to aforesaid sample 21, except that a substrate was subjected to following pre-treatment A before being exposed to an indirectly excited discharge gas.

Pre-Treatment A: Before being exposed to an indirectly excited discharge gas, a discharge gas comprising "an argon gas"/"an oxygen gas" = 1/1 (volume ratio) was introduced into a discharge space constituted of the first electrode and the second electrode being arranged to oppose to each other and a substrate was exposed to the excited discharge gas. Herein, as a high frequency electric power source was utilized High Frequency Electric power source, produced by Pearl Industrial Co., Ltd. (frequency number: 13.56 MHz) at a discharge power of 10 W/cm².

### [Preparation of Sample 35]

Sample 35 was prepared in a similar manner to aforesaid sample 21, except that a substrate was subjected to following pre-treatment B before being exposed to an indirectly excited discharge gas.

Pre-Treatment B: Before being exposed to an indirectly excited discharge gas, a substrate was exposed to a discharge space where a discharge gas comprising "an argon gas"/"an oxygen gas" = 1/1 (volume ratio) was supplied by utilizing the discharge apparatus constituted of a pair of roll electrodes, a gap distance of which was 1 mm, shown in Fig. 7. Herein, as a high frequency electric power source utilized was High Frequency Electric power source, produced by Pearl Industrial Co., Ltd. (13.56 MHz) and a discharge power of 5.0 W/cm² was applied to the second electrode. [Preparation of Sample 36]

Sample 36 was prepared in a similar manner to sample 21, except that sheet glass (Product name: 0.5t Soda Glass, one-side polished type, manufactured by Nippon Sheet Glass Co., Ltd.) was utilized as a substrate.

### [Preparation of Sample 37]

Sample 37 was prepared in a similar manner to sample 21, except that polyethylene terephthalate film having a thickness of 100 µm (being noted as PET in Table 3) was utilized as a substrate.

### [Preparation of Sample 38]

Sample 38 was prepared in a similar manner to sample 37, except that High Frequency Electric power source, produced by Shinko Denki Co., Ltd. (frequency number: 15 kHz) was utilized instead of High Frequency Electric power source, produced by Pearl Industrial Co., Ltd. (frequency number: 13.56 MHz) as high frequency electric power source 5.

### [Preparation of Sample 39]

Comparative sample 39 was prepared in a similar manner to sample 38, except that 6-fluoropropylene was utilized instead of organometallic compound (exemplary compound 15) as gas type B (thin film forming gas).

### [Preparation of Sample 40]

Comparative sample 40 was prepared in a similar manner to sample 39, except that a substrate of sample 21 (TAC) was utilized instead of polyethylene terephthalate film having a thickness of 100 µm.

Primary characteristics of a thin film forming method of each sample are shown in Table 3.

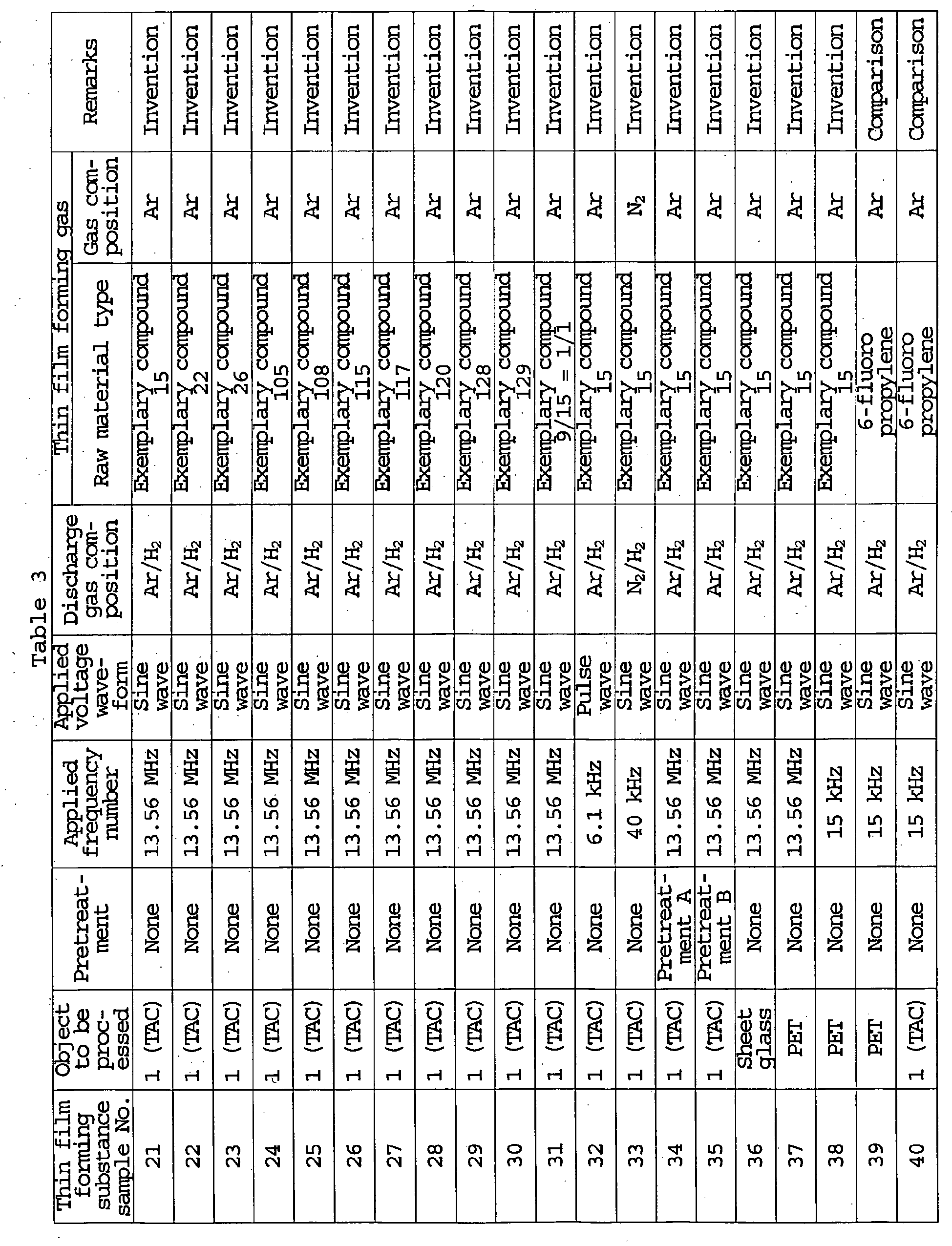

### <Measurement of Characteristics of Each Sample and Evaluation>

Evaluations similar to those in example 1 were performed.

Results obtained above except a surface specific resistance are shown in Table 4.

**Table 4**

| Thin film formed substance sample No. | Contact angle | | Oil-based ink writability | Oil-based oil- ink wiping-off property | | Abrasion resistance | Remarks |
|---|---|---|---|---|---|---|---|
| | Water | Hexadecane | | lst time | 20th time | | |
| 21 | 105 | 68 | A | A | B | A | Invention |
| 22 | 104 | 67 | A | A | B | A | Invention |
| 23 | 101 | 65 | B | B | B | A | Invention |
| 24 | 101 | 62 | B | B | B | A | Invention |
| 25 | 104 | 66 | A | A | B | A | Invention |
| 26 | 99 | 60 | B | B | B | B | Invention |
| 27 | 100 | 61 | B | B | B | B | Invention |
| 28 | 101 | 63 | B | B | B | A | Invention |
| 29 | 105 | 67 | A | A | B | A | Invention |
| 30 | 104 | 68 | A | A | B | A | Invention |
| 31 | 103 | 68 | A | A | B | A | Invention |
| 32 | 111 | 73 | A | A | B | A | Invention |
| 33 | 111 | 72 | A | A | B | A | Invention |
| 34 | 110 | 71 | A | A | B | A | Invention |
| 35 | 111 | 72 | A | A | B | A | Invention |
| 36 | 105 | 68 | A | A | B | A | Invention |
| 37 | 100 | 65 | B | B | B | B | Invention |
| 38 | 97 | 63 | B | B | B | B | Invention |
| 39 | 92 | 50 | C | B | C | C | Comparison |
| 40 | 94 | 45 | C | C | C | D | Comparison |

It is clear from Table 4 that samples of the invention, in which an organometallic compound with an organic group containing a fluorine atom is contained as a thin film forming gas and an anti-stain film is formed by a thin film forming method of the invention, exhibit an excellent water-repellency, oil-repellency and an oil-based ink wiping-off property as well as excellent abrasion resistance of an anti-stain film formed, compared to comparative examples. Further, it is clear by comparing sample 33 and sample 21 that a repeating resistance of an oil-based ink wiping-off property is improved by replacing an argon gas employed in a discharge gas and a thin film forming gas with a nitrogen gas. Herein, in samples 1 to 15 (the invention) of example 1, an oil-based ink wiping-off property was not deteriorated (A) even at 50 times, while in samples 21 - 38 (the invention) of example 2, an oil-based ink wiping-off property was deteriorated (B) resulting in a little residue of ink at 50 times. That is, it is clear that the thin film forming method by use of apparatus of Fig. 2 is superior to that of Fig. 5 also with respect to oil-repellency.

### INDUSTRIAL APPLICABILITY

The invention can provide a thin film forming method and a thin film formed substance , which exhibit no effect on a substrate; excellent water-repellency, oil-repellency and an oil-based ink wiping-off property; as well as excellent abrasion resistance.

## Claims

1. A thin film forming method comprising:
introducing a discharge gas into a discharge space to be excited under an atmospheric pressure or an approximately atmospheric pressure;
contacting a thin film forming gas comprising an organometallic compound with an organic group containing a fluorine atom, with the excited discharge gas to be converted into an indirectly excited gas at outside of the discharge space; and
exposing a substrate to said indirectly excited gas to form a thin film on said substrate.

2. The thin film forming method of claim 1, wherein said discharge gas is introduced into and released from each of a first discharge space formed between a first pair of electrodes and a second discharge space formed between a second pair of electrodes in approximately the same direction, said thin film forming gas is introduced into and released from a third space sandwiched by said first pair of electrodes and said second pair of electrodes in approximately the same direction as said discharge gas introducing and releasing direction and said thin film forming gas is contacted with said excited discharge gas near the releasing part of said third space to be converted into said indirectly excited gas.

3. The thin film forming method of claim 1, wherein said excited discharge gas and said thin film forming gas are supplied separately on the surface of said substrate.

4. The thin film forming method of claim 1, wherein said organometallic compound with an organic group containing a fluorine atom is a compound represented by following general formula (1). 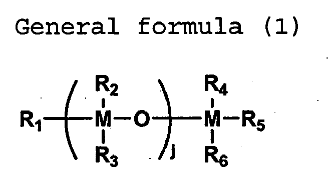 [wherein, M represents Si, Ti, Ge, Zr or Sn, and R₁ to R₆ each represent a hydrogen atom or a monovalent group, at least one of groups represented by R₁ to R₆ being a group having a fluorine atom. j represents 0 or an integer of 1 to 150.]

5. The thin film forming method of claim 4, wherein said compound represented by said general formula (1) is a compound represented by following general formula (2).
General formula (2) [Rf-X-(CH₂)ₖ]_{q}-M(R₁₀)ᵣ(OR₁₁)ₜ
[wherein, M represents Si, Ti, Ge, Zr or Sn, and Rf represents an alkyl or alkenyl group in which at least one of hydrogen atoms being substituted with a fluorine atom; and X represents a single bond or a bivalent group. R₁₀ represents an alkyl group or an alkenyl group, and R₁₁ represents an alkyl group, an alkenyl group or an aryl group. Further, k represents 0 or an integer of 1 to 50, q + r + t = 4, q ≥ 1 and t ≥ 1. Further, two of R₁₀ may form a ring by bonding together when r ≥ 2.]

6. The thin film forming method of claim 5, wherein said compound represented by said general formula (2) is a compound represented by following general formula (3).
General formula (3) Rf-X- (CH₂)ₖ-M (OR₁₂)₃
[wherein, M represents Si, Ti, Ge, Zr or Sn; Rf represents an alkyl or alkenyl group in which at least one of hydrogen atoms is substituted with a fluorine atom; and X represents a single bond or a bivalent group. R₁₂ represents an alkyl group, an alkenyl group or an aryl group. k represents 0 or an integer of 1 to 50.]

7. The thin film forming method of claim 1, wherein said organometallic compound with an organic group containing a fluorine atom is a compound represented by following general formula (4). 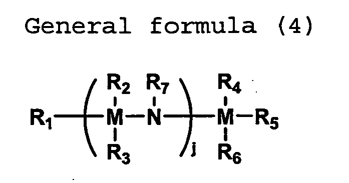 [wherein, M represents Si, Ti, Ge, Zr or Sn, and R₁ to R₆ each represent a hydrogen atom or a monovalent group, at least one of groups represented by R₁ to R₆ being a group having a fluorine atom. R₇ is a hydrogen atom or a substituted or non-substituted alkyl group. j represents 0 or an integer of 1 to 150.]

8. The thin film forming method of claim 1, wherein said organometallic compound with an organic group containing a fluorine atom is a compound represented by following general formula (5).
General formula (5) [Rf-X-(CH₂)ₖ-Y]ₘ-M(R₈)ₙ(OR₉)ₚ
[wherein, M represents In, Al, Sb, Y or La, and Rf represents an alkyl or alkenyl group in which at least one of hydrogen atoms is substituted by a fluorine atom. X represents a single bond or a bivalent group, Y represents a single bond or an oxygen atom. R₈ represents substituted or non-substituted alkyl, alkenyl or aryl group, and R₉ represents substituted or non-substituted alkyl or alkenyl group. k represents 0 or an integer of 1 to 50, and m + n + p = 3, m being at least 1, and n, p each represents 0 or an integer of 1 to 2.]

9. The thin film forming method of claim 1, wherein said organometallic compound with an organic group containing a fluorine atom is a compound represented by following general formula (6).
General formula (6) R^{f1}(OC₃F₆)ₘ₁―O―(CF₂)ₙ₁―(CH₂)ₚ₁―Z―(CH₂)_{q1}―Si―(R²)₃
[wherein, R^{f1} represents a straight chain or branched perfluoroalkyl group having a carbon number of 1 to 16, R² represents a hydrolysable group, Z represents -OCONH- or -O-, m1 represents an integer of 1 to 50, n1 represents 0 or an integer of 1 to 3, p1 represents 0 or an integer of 1 to 3, q1 represents an integer of 1 to 6, and 6 ≥ n1 + p1 > 0.]

10. The thin layer forming method of claim 1, wherein said organometallic compound with an organic group containing a fluorine atom is a compound represented by following general formula (7). 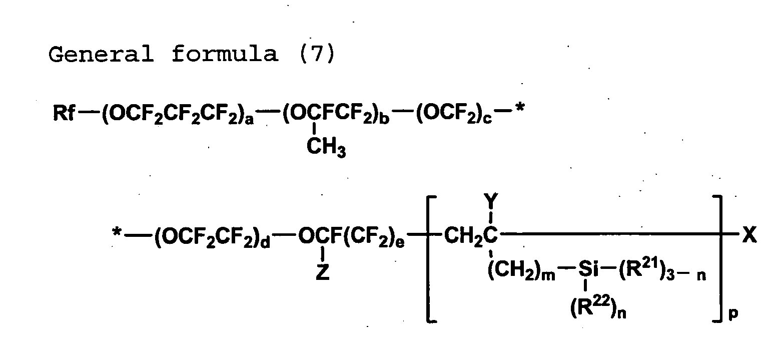 [wherein,Rf represents a straight chain or branched perfluoroalkyk group; X represents an iodine atom or a hydrogen atom; Y rpresents a hydrogen atom or a lower alkyl group; Z represents a fluorine atom or a trifluoromethyl group; R²¹ represents a hydrolysable group; R²² represents a hydrogen atom or an inert monovalent organic group; a, b c and d each represents 0 or an integer of 1 to 200; e represents 0 or 1; m and n represent 0 or an integer of 1 to 2; and p represents an integer of 1 to 10.]

11. The thin film forming method of any of claims 1 to 10, wherein said discharge space is comprised of a high frequency electric field.

12. The thin film forming method of any of claims 1 to 11, wherein said discharge gas contains a rare gas.

13. The thin film forming method of any of claims 1 to 12, wherein said discharge gas contains a nitrogen gas.

14. The thin film forming method of any of claims 1 to 13, wherein said substrate is exposed to said indirectly excited gas after a pre-treatment by exposing the substrate to a discharge space or to an excited discharge gas.

15. The thin film forming method of any of claims 1 to 14, wherein the surface of said substrate, on which said thin film is formed, contains an inorganic compound.

16. The thin film forming method of any of claims 1 to 15, wherein the main component of the substrate surface, on which the aforesaid thin film is formed, is a metal oxide.

17. A thin film formed substance comprising a substrate provided thereon a thin film, wherein the thin film is formed by the thin film forming method in any one of claims 1 to 16.

18. The thin film formed substance of claim 17, wherein a surface electrical resistance of the thin film is not more than 1 x 10¹²Ω/□ under a condition of 23 °C and 55% RH.
